(19) Europäisches Patentamt / European Patent Office / Office européen des brevets

(11) **EP 4 601 438 A1**

(12) **EUROPEAN PATENT APPLICATION**

(43) Date of publication:
**13.08.2025 Bulletin 2025/33**

(21) Application number: **25152745.3**

(22) Date of filing: **20.01.2025**

(51) International Patent Classification (IPC):
*H10K 50/115* (2023.01)     *H10K 50/16* (2023.01)

(52) Cooperative Patent Classification (CPC):
**H10K 50/115; H10K 50/16; H10K 2102/331**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **07.02.2024 KR 20240019203**

(71) Applicant: SAMSUNG ELECTRONICS CO., LTD.
**Yeongtong-gu**
**Suwon-si, Gyeonggi-do 16677 (KR)**

(72) Inventors:
• **PARK, Su Jin**
  **16678 Suwon-si (KR)**
• **KIM, Sung Woo**
  **16678 Suwon-si (KR)**
• **CHUNG, You Jung**
  **16678 Suwon-si (KR)**
• **HWANG, Sungwoo**
  **16678 Suwon-si (KR)**
• **KIM, Jina**
  **16678 Suwon-si (KR)**
• **LEE, Ilyoung**
  **16678 Suwon-si (KR)**
• **CHUNG, Heejae**
  **16678 Suwon-si (KR)**
• **CHA, Soonmin**
  **16678 Suwon-si (KR)**

(74) Representative: **Elkington and Fife LLP**
**Prospect House**
**8 Pembroke Road**
**Sevenoaks, Kent TN13 1XR (GB)**

(54) **QUANTUM DOT LIGHT EMITTING DEVICE AND METHOD OF MANUFACTURING THE SAME AND ELECTRONIC DEVICE**

(57)     A method of manufacturing an quantum dot light emitting device, a quantum dot light emitting device, and an electronic device, the method including: forming an anode, forming a quantum dot light emitting layer on the anode, forming an electron auxiliary layer including alkaline-earth metal containing oxide nanoparticles on the quantum dot light emitting layer, and forming a cathode on the electron auxiliary layer, wherein the forming of the electron auxiliary layer includes: preparing a precursor dispersion including an alkaline-earth metal precursor, preparing a basic reagent solution containing a basic reagent, adding the basic reagent solution into the precursor dispersion dropwise at a controlled rate to grow alkaline-earth metal containing oxide nanoparticles, dispersing the alkaline-earth metal containing oxide nanoparticles in a dispersion medium to prepare an alkaline-earth metal containing oxide nanoparticle dispersion, and coating the alkaline-earth metal containing oxide nanoparticle dispersion on the quantum dot light emitting layer.

FIG. 1

<u>10</u>

EP 4 601 438 A1

**Description**

FIELD OF THE INVENTION

A quantum dot light emitting device, a method of manufacturing the same, and an electronic device are disclosed.

BACKGROUND OF THE INVENTION

Physical characteristics (e.g., bandgap energies, melting points, etc.) of nanoparticles that are intrinsic characteristics may be controlled by changing the particle sizes of the nanoparticles, unlike bulk materials. For instance, semiconductor nanocrystal particles, also referred to as quantum dots, are a crystalline material having a nano-sized crystal structure. The quantum dots may be supplied with photoenergy or electrical energy and may be configured to emit light in a wavelength corresponding to sizes of the quantum dots. Accordingly, the quantum dots may be used as a light emitting element emitting light of a particular wavelength.

SUMMARY OF THE INVENTION

A light emitting device can use quantum dots as a light emitting material. The quantum dots are different from a conventional light emitting material, and thus a new solution to improve the performance of a quantum dot light emitting device is desired and herein realized.
An embodiment provides a quantum dot light emitting device capable of implementing improved performance.
An embodiment provides a method of manufacturing the quantum dot light emitting device.
An embodiment provides an electronic device including the quantum dot light emitting device.
In an embodiment, a method of manufacturing a quantum dot light emitting device includes: forming an anode, forming a quantum dot light emitting layer on the anode, forming an electron auxiliary layer on the quantum dot light emitting layer, the electron auxiliary layer including alkaline-earth metal containing oxide nanoparticles, and forming a cathode on the electron auxiliary layer,
wherein the forming of the electron auxiliary layer includes: preparing a precursor dispersion including an alkaline-earth metal precursor, preparing a basic reagent solution containing a basic reagent, and adding the basic reagent solution into the precursor dispersion by dropping dropwise at a controlled rate to grow alkaline earth metal containing oxide nanoparticles, dispersing the alkaline-earth metal containing oxide nanoparticles in a dispersion medium to prepare an alkaline-earth metal containing oxide nanoparticle dispersion, and coating the alkaline-earth metal containing oxide nanoparticle dispersion on the quantum dot light emitting layer.
The basic reagent may include an inorganic alkali hydroxide.
The inorganic alkali hydroxide may include CsOH, RbOH, KOH, NaOH, LiOH, or any combination thereof.
The basic reagent solution may be adding by dropping dropwise at a rate of about 0.1 millimole/minute (mmol/min) to about 1.5 mmol/min.
The basic reagent solution may be injected by dropping at a rate of about 0.2 mmol/min to about 1.2 mmol/min.
The precursor dispersion may include a zinc precursor.
The alkaline-earth metal containing oxide nanoparticles may have a modified and improved shape and size, and may satisfy Relational Equation 1.

$$\text{Relational Equation 1}$$

$$0.075 \leq 1 - (Abs_{valley} / Abs_{peak}) \leq 0.095$$

In Relational Equation 1,

$Abs_{peak}$ is an absorbance at a peak of the ultraviolet-visible (UV-Vis) absorption spectrum, and
$Abs_{valley}$ is an absorbance at a lowest point of the valley adjacent to the peak of the ultraviolet-visible (UV-Vis) absorption spectrum.

An average particle diameter of the alkaline-earth metal containing oxide nanoparticles may be about 1.2 nanometer (nm) to about 2.2 nm.
An average particle diameter of aggregates of the alkaline-earth metal containing oxide nanoparticles measured by dynamic light scattering (DLS) may be about 6 nm to about 15 nm.
An average circularity of the alkaline-earth metal containing oxide nanoparticles may be about 0.70 to about 1.00.

According to an embodiment, a quantum dot light emitting device includes an anode and a cathode, a quantum dot light emitting layer between the anode and the cathode, and an electron auxiliary layer including alkaline-earth metal containing oxide nanoparticles between the cathode and the quantum dot light emitting layer, wherein the alkaline-earth metal containing oxide nanoparticles satisfies Relational Equation 1.

An average particle diameter of the alkaline-earth metal containing oxide nanoparticles may be about 1.2 nm to about 2.2 nm.

An average particle diameter of aggregates of the alkaline-earth metal containing oxide nanoparticles measured by dynamic light scattering (DLS) may be about 6 nm to about 15 nm.

An average circularity of the alkaline-earth metal containing oxide nanoparticles may be about 0.70 to about 1.00.

The alkaline-earth metal may be magnesium.

The alkaline-earth metal containing oxide nanoparticles may include zinc.

A content of the alkaline-earth metal included in the alkaline-earth metal containing oxide nanoparticles may be about 0.01 to about 30 atomic percentage (at%) based on a total number of atoms of the alkaline-earth metal and zinc.

The alkaline-earth metal containing oxide nanoparticles may include an element of Cs, Rb, K, Na, Li, or a combination thereof, or a salt thereof.

The quantum dot light emitting device may include a hole auxiliary layer between the anode and the quantum dot light emitting layer and including an organic material.

According to an embodiment, an electronic device including the quantum dot light emitting device is provided.

Advantageously, the performance of quantum dot light emitting devices can be improved as a result of embodiments of this disclosure.

BRIEF DESCRIPTION OF THE DRAWINGS

The above and other advantages and features of this disclosure will become more apparent by describing in further detail exemplary embodiments thereof with reference to the accompanying drawings, in which:

FIG. 1 is a cross-sectional view schematically showing a quantum dot light emitting device according to an embodiment,

FIG. 2 is a Transmission electron microscope (TEM) photograph of alkaline-earth metal oxide nanoparticles according to Preparation Example 3,

FIG. 3 is a TEM photograph of alkaline-earth metal oxide nanoparticles prepared according to Comparative Preparation Example 1,

FIG. 4 is a graph of normalized absorption intensity (arbitrary units (A.U.) versus wavelength (nm) showing ultraviolet-visible (UV-Vis) absorption spectrum of the alkaline-earth metal oxide nanoparticles according to Preparation Examples 2 and 3, and Comparative Preparation Example 1,

FIG. 5 is a graph showing an enlargement of the valley area of the ultraviolet-visible (UV-Vis) absorption spectrum of FIG. 4,

FIG. 6 is a graph showing the ultraviolet-visible (UV-Vis) absorption spectrum according to the dropping time in minutes of the basic reagent solution during the synthesis of alkaline-earth metal oxide nanoparticles according to Preparation Examples 2 and 3, and

FIG. 7 is a graph of photoluminescence (PL) intensity (normalized) versus time (nanoseconds (ns)) showing the photoluminescence life-span characteristics of sample devices according to Examples 1 and 2, and Comparative Example 1.

DETAILED DESCRIPTION OF THE EMBODIMENTS

Hereinafter, example embodiments of the present disclosure will be described in detail so that a person skilled in the art would understand the same. This disclosure may, however, be embodied in many different forms and is not construed as limited to the example embodiments set forth herein.

In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it can be directly on the other element or intervening elements may also be present. In contrast, when an element is referred to as being "directly on" another element, there are no intervening elements present.

It will be understood that, although the terms "first," "second," "third," etc., may be used herein to describe various elements, components, regions, layers, and/or sections, these elements, components, regions, layers and/or sections should not be limited by these terms. These terms are only used to distinguish one element, component, region, layer, or section from another element, component, region, layer, or section. Thus, "a first element," "component," "region," "layer," or "section" discussed below could be termed a second element, component, region, layer, or section without departing from the teachings herein.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

"About" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, or 5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Herein, "combination" includes a mixture or a stacked structure of two or more.

As used herein, when specific definition is not otherwise provided, an energy level refers to the highest occupied molecular orbital (HOMO) energy level and the lowest unoccupied molecular orbital (LUMO) energy level.

Herein, a value of a work function, conduction band, or lowest unoccupied molecular orbital (LUMO) energy level, or valence band or highest occupied molecular orbital (HOMO) energy level is expressed as an absolute value from a vacuum level. In addition, a deep, high, or large work function or energy level means that the absolute value is large when the vacuum level is set to "0 electrovolts (eV)," and a shallow, low, or small work function or energy level means that the absolute value is small when the vacuum level is set to "0 eV."

The HOMO energy level and work function may be measured by ultraviolet photoelectron spectroscopy (UPS), and the LUMO energy level may be calculated from the energy bandgap obtained at the absorption peak and the HOMO energy level.

As used herein, the term "Group" refers to a group of Periodic Table.

As used herein, "Group I" refers to Group IA and Group IB, and examples may include Li, Na, K, Rb, and Cs, but are not limited thereto.

As used herein, "Group II" refers to Group IIA and Group IIB, and examples of Group II metal may be Cd, Zn, Hg, and Mg, but are not limited thereto.

As used herein, "Group III" refers to Group IIIA and Group IIIB, and examples of Group III metal may be Al, In, Ga, and TI, but are not limited thereto.

As used herein, "Group IV" refers to Group IVA and Group IVB, and examples of a Group IV metal may be Si, Ge, and Sn, but are not limited thereto.

As used herein, "metal" includes a metal and a semi-metal such as Si.

As used herein, "Group V" includes Group VA and includes nitrogen, phosphorus, arsenic, antimony, and bismuth, but is not limited thereto.

As used herein, "Group VI" includes Group VIA and includes sulfur, selenium, and tellurium, but is not limited thereto.

As used herein, a description of "not including cadmium (or other toxic/harmful heavy metal)" means that the concentration of the cadmium (or the corresponding heavy metal) is less than or equal to about 100 parts per million (ppm) (by weight), less than or equal to about 50 ppm, less than or equal to about 10 ppm, less than or equal to about 0.01 ppm, or almost zero. In an embodiment, substantially no cadmium (or other heavy metal) is present or, if present, in an amount below the detection limit of a given analysis/detection tool or at an impurity level.

As used herein, when a definition is not otherwise provided, 'substituted' refers to a replacement of a hydrogen atom of a compound, a functional group, or moiety by a substituent such as a C1 to C30 alkyl group, a C2 to C30 alkenyl group, a C2 to C30 alkynyl group, a C2 to C30 epoxy group, a C2 to C30 alkylester group, a C3 to C30 alkenylester group (e.g., acrylate group, methacrylate group), a C6 to C30 aryl group, a C7 to C30 alkylaryl group, a C1 to C30 alkoxy group, a C1 to C30 heteroalkyl group, a C3 to C30 heteroalkylaryl group, a C3 to C30 cycloalkyl group, a C3 to C15 cycloalkenyl group, a C6 to C30 cycloalkynyl group, a C2 to C30 heterocycloalkyl group, a halogen (-F, -Cl, -Br, or -I), a hydroxy group (-OH), a nitro group ($-NO_2$), a cyano group (-CN), an amino group (-NRR', wherein R and R' are each independently hydrogen or a C1 to C6 alkyl group), an azido group ($-N_3$), an amidino group ($-C(=NH)NH_2$), a hydrazino group ($-NHNH_2$), a hydrazono group ($=N(NH_2)$), an aldehyde group (-C(=O)H), a carbamoyl group ($-C(O)NH_2$), a thiol group (-SH), an ester group (-C(=O)OR, wherein R is a C1 to C6 alkyl group or a C6 to C12 aryl group), a carboxyl group (-COOH) or a salt thereof (-C(=O)OM, wherein M is an organic or inorganic cation), a sulfonic acid group (-SOsH) or a salt thereof (-SOsM, wherein M is an organic or inorganic cation), a phosphoric acid group ($-PO_3H_2$) or a salt thereof ($-POsMH$ or $-PO_3M_2$, wherein M is an organic or inorganic cation), or a combination thereof.

As used herein, when a definition is not otherwise provided, "hydrocarbon group" refers to a group including carbon and hydrogen (e.g., alkyl, alkenyl, alkynyl, or aryl group). The hydrocarbon group may be a group having a monovalence or more formed by removal of one or more hydrogen atoms from alkane, alkene, alkyne, or arene. In the hydrocarbon group, a, e.g., at least one, methylene may be replaced by an oxide moiety, a carbonyl moiety, an ester moiety, -NH-, or a combination thereof. Unless otherwise stated to the contrary, the hydrocarbon (alkyl, alkenyl, alkynyl, or aryl) group may have 1 to 60, 2 to 32, 3 to 24, or 4 to 12 carbon atoms.

As used herein, "aliphatic" refers to a saturated or unsaturated linear or branched hydrocarbon group. An aliphatic group may be an alkyl, alkenyl, or alkynyl group, for example.

As used herein, when a definition is not otherwise provided, "alkyl" refers to a linear or branched saturated monovalent hydrocarbon group (methyl, ethyl hexyl, etc.).

As used herein, when a definition is not otherwise provided, "alkenyl" refers to a linear or branched monovalent hydrocarbon group having a carbon-carbon double bond.

As used herein, when a definition is not otherwise provided, "alkynyl" refers to a linear or branched monovalent hydrocarbon group having a carbon-carbon triple bond.

As used herein, when a definition is not otherwise provided, "aryl" refers to a group formed by removal of a, e.g., at least one, hydrogen from an arene (e.g., a phenyl or naphthyl group).

As used herein, when specific definition is not otherwise provided, the prefix "hetero" refers to including 1 to 4 heteroatoms selected from N, O, S, Se, Te, Si, and P.

As used herein, when a definition is not otherwise provided, "alkoxy" means an alkyl group linked via an oxygen (i.e., alkyl-O-), such as a methoxy, ethoxy, or sec-butyloxy group.

As used herein, when a definition is not otherwise provided, an "amine group" may be -NRR (wherein R is independently hydrogen, a C1 to C12 alkyl group, a C7 to C20 alkylaryl group, a C7 to C20 arylalkyl group, or a C6 to C18 aryl group).

Hereinafter, a quantum dot light emitting device according to some embodiments is described with reference to the drawings.

The quantum dot light emitting device according to an embodiment may be a quantum dot electroluminescent device that emits light from the quantum dot by applying an electric field to electrodes.

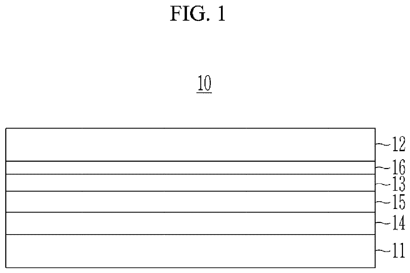

FIG. 1 is a cross-sectional view schematically showing a quantum dot light emitting device according to an embodiment.

Referring to FIG. 1, a quantum dot light emitting device 10 according to an embodiment includes an anode 11 and a cathode 12 facing each other as two opposing electrodes; a quantum dot light emitting layer 13 between the anode 11 and the cathode 12; hole auxiliary layers 14 and 15 between the anode 11 and the quantum dot light emitting layer 13; and an electron auxiliary layer 16 between the cathode 12 and the quantum dot light emitting layer 13.

The substrate (not shown) may be disposed under the anode 11 or may be disposed on the cathode 12, or at any other desired location of the quantum dot light emitting device 10. The substrate may include an insulating material (e.g., insulating transparent substrate). The substrate may include, for example, an inorganic material such as glass, silicon, silicon oxide, $Al_2O_3$, and the like; an organic material such as polycarbonate, polymethylmethacrylate, polyethylene terephthalate (PET), polyethylene naphthalate (PEN), polyamide, polyethersulfone; or any combination thereof; or a silicon wafer, but is not limited thereto. Herein "transparent" refers to having a transmittance with respect to a light in a predetermined wavelength (e.g., light emitted from the quantum dots) of greater than or equal to about 85%, for example, greater than or equal to about 88%, greater than or equal to about 90%, greater than or equal to about 95%, greater than or equal to about 97%, or greater than or equal to about 99%. A thickness of the substrate may be appropriately selected considering a substrate material, but is not particularly limited. The transparent substrate may have flexibility. The substrate may be omitted.

The anode 11 may be made of a conductor having a relatively deep work function, for example, a metal, a conductive metal oxide, or any combination thereof. The anode 11 may be made of, for example, a metal or an alloy thereof such as nickel, platinum, vanadium, chromium, copper, zinc, or gold; a conductive metal oxide such as zinc oxide, indium oxide, tin oxide, indium tin oxide (ITO), indium zinc oxide (IZO), or a fluorine-doped tin oxide; or a combination of metal and oxide such as ZnO and Al or $SnO_2$ and Sb, but is not limited thereto. In an embodiment, the anode 11 may include a transparent conductive metal oxide, for example, ITO.

The cathode 12 may be made of a conductor having a shallower, e.g., lower or less, work function than the anode 11 and may be made of, for example, a metal, a conductive metal oxide, a conductive polymer, or a combination thereof. The cathode 12 may include, for example, a metal such as aluminum, magnesium, calcium, sodium, potassium, titanium, indium, yttrium, lithium, gadolinium, silver, tin, lead, cesium, barium, or an alloy thereof; a multilayer structure material such as LiF/Al, $Li_2O$/Al, 8-hydroxyquinolinolato-lithium (Liq)/Al, LiF/Ca, or $BaF_2$/Ca; a combination thereof, but is not limited thereto. In an embodiment, the cathode 12 may include a transparent conductive metal oxide, for example, ITO. A work function of the anode 11 may be deeper, e.g., higher or greater, than that of the cathode 12. As an example, the work function of the anode 11 may be, for example, about 4.5 eV to about 5.0 eV, including about 4.6 eV, about 4.7 eV, about 4.8 eV, and about 4.9 eV, and the work function of the cathode 12 may be for, example, about 4.0 eV to about 4.7 eV, including about 4.1 eV, about 4.2 eV, about 4.3 eV, about 4.4 eV, about 4.5 eV, and about 4.6 eV. Within the above range, the work function of the anode 11 may be, for example, about 4.6 eV to about 4.9 eV, and the work function of the cathode 12 may be, for example, about 4.0 eV to about 4.5 eV. Still further within the above range, the work function of the anode 11 may be, for example, about 4.7 eV to about 4.8 eV, and the work function of the cathode 12 may be, for example, about 4.2 eV to about 4.4 eV.

The anode 11, the cathode 12, or a combination thereof, may be a light-transmitting electrode, and the light-transmitting electrode may be, for example, made of a conductive oxide such as a zinc oxide, indium oxide, tin oxide, indium tin oxide (ITO), indium zinc oxide (IZO), or fluorine doped tin oxide, or a metal thin layer of a single layer or a multilayer. Any one of the anode 11 or the cathode 12 may be an opaque electrode, and the opaque electrode may be made of, for example, an opaque conductor such as aluminum (Al), silver (Ag), or gold (Au).

A thickness of the electrodes (the anode 11, the cathode 12, or each of the anode 11 and the cathode 12) is not particularly limited and may be appropriately selected considering device efficiency. For example, the thickness of the electrodes may be greater than or equal to about 5 nm, for example, greater than or equal to about 50 nm, or greater than or equal to about 100 nm. For example, the thickness of the electrodes may be less than or equal to about 100 micrometers ($\mu$m), for example, less than or equal to about 10 $\mu$m, less than or equal to about 1 $\mu$m, less than or equal to about 900 nm, less than or equal to about 500 nm, less than or equal to about 400 nm, less than or equal to about 300 nm, less than or equal to about 200 nm, or less than or equal to about 100 nm. The quantum dot light emitting layer 13 includes, e.g., a plurality of quantum dots as a light emitting material configured to emit light by an electric field. A quantum dot refers to a semiconductor nanocrystal in a broad sense, and may exhibit a quantum confinement effect.

Herein, the quantum dot may have any shape, and the shape is not particularly limited. For example, quantum dots may have various shapes, such as the shape of a sphere, a polyhedron, a pyramid, a multipod shape, a hexahedron, a cube, a cuboid, a nanotube, a nanorod, a nanowire, a nanosheet, an isotropic semiconductor nanocrystal, a quantum rod, a quantum plate, or a combination thereof. A multipod shape may have at least two (e.g., at least three or at least four) branch portions and a valley portion therebetween.

Herein, quantum rod refers to a quantum dot having an aspect ratio greater than about 1, for example, an aspect ratio of greater than or equal to about 2, greater than or equal to about 3, or greater than or equal to about 5. For example, an aspect ratio of the quantum rod may be less than or equal to about 50, less than or equal to about 30, or less than or equal to about 20.

The quantum dot may have, for example, a particle diameter (an average largest particle diameter for a non-spherical shape) of about 1 nm to about 100 nm, for example, about 1 nm to about 80 nm, for example, about 1 nm to about 50 nm, or for example, about 1 nm to about 20 nm. In an embodiment, the (average) size of the quantum dot(s) may be greater than or equal to about 1 nm, greater than or equal to about 2 nm, greater than or equal to about 3 nm, greater than or equal to about 4 nm, greater than or equal to about 5 nm, greater than or equal to about 6 nm, greater than or equal to about 7 nm, greater than or equal to about 8 nm, greater than or equal to about 9 nm, greater than or equal to about 10 nm, greater than or equal to about 11 nm, or greater than or equal to about 12 nm. In an embodiment, the (average) size of the quantum dot(s) may be less than or equal to about 50 nm, less than or equal to about 40 nm, less than or equal to about 30 nm, less than or equal to about 25 nm, less than or equal to about 20 nm, less than or equal to about 19 nm, less than or equal to about 18 nm, less than or equal to about 17 nm, less than or equal to about 16 nm, or less than or equal to about 15 nm. For example, the average size of a quantum dot (e.g., emitting blue light) may be less than or equal to about 4.5 nm, for example, less than or equal to about 4.3 nm, less than or equal to about 4.2 nm, less than or equal to about 4.1 nm, or less than or equal to about 4.0 nm. In an embodiment, the (average) size of the quantum dots may be about 2.0 nm to about 4.5 nm, about 2.0 nm to about 4.3 nm, about 2.0 nm to about 4.2 nm, about 2.0 nm to about 4.1 nm, or about 2.0 nm to about 4.0 nm. The "average" may refer to mean, mode, or median.

Energy bandgaps of quantum dots may be controlled according to size and composition of the quantum dots, and thus emission wavelength may be controlled. For example, as the size of quantum dots increases, the quantum dots may have narrow energy bandgaps and thus emit light in a relatively long wavelength region. In contrast, as the size of the quantum dots decreases, the quantum dots may have wide energy bandgap and thus emit light in a relatively short wavelength region.

For example, the quantum dot may be configured to emit light in a predetermined wavelength region of a visible light region according to its size, composition, or a combination thereof. For example, the quantum dot may be configured to emit blue light, red light, or green light, and the blue light may have, for example, a maximum emission wavelength (or referred to as peak emission wavelength) ($\lambda_{max,L}$) of about 430 nm to about 480 nm, the red light may have, for example, a maximum emission wavelength of about 600 nm to about 670 nm, and the green light may have, for example, a maximum emission wavelength ($\lambda_{max,L}$) of about 520 nm to about 560 nm.

In the quantum dot light emitting device 10 of an embodiment, a maximum emission wavelength ($\lambda_{max,L}$) of the quantum dot light emitting layer 13 or quantum dots may be greater than or equal to about 300 nm, greater than or equal to about 400 nm, greater than or equal to about 430 nm, greater than or equal to about 450 nm, for example, greater than or equal to about 500 nm, greater than or equal to about 510 nm, greater than or equal to about 520 nm, greater than or equal to about 530 nm, greater than or equal to about 540 nm, greater than or equal to about 550 nm, greater than or equal to about 560 nm, greater than or equal to about 570 nm, greater than or equal to about 580 nm, greater than or equal to about 590 nm, greater than or equal to about 600 nm, or greater than or equal to about 610 nm. The maximum emission wavelength ($\lambda_{max,L}$) of the quantum dot light emitting layer 13 or quantum dots may be in the range of less than or equal to about 800 nm, less than or equal to about 780 nm, less than or equal to about 750 nm, less than or equal to about 700 nm, less than or equal to about 670 nm, less than or equal to about 650 nm, less than or equal to about 640 nm, less than or equal to about 630 nm, less than or equal to about 620 nm, less than or equal to about 610 nm, less than or equal to about 600 nm, less than or equal to about 590 nm, less than or equal to about 580 nm, less than or equal to about 570 nm, less than or equal to about 560 nm, less than or equal to about 550 nm, or less than or equal to about 540 nm. The maximum emission wavelength ($\lambda_{max,L}$) of the quantum dot light emitting layer 13 or quantum dots may be in the range of about 430 nm to about 670 nm.

In the quantum dot light emitting device 10 of an embodiment, the quantum dot light emitting layer 13 or quantum dots may be configured to emit green light, and the maximum emission wavelength ($\lambda_{max,L}$) may be in the range of greater than or equal to about 500 nm (e.g., greater than or equal to about 510 nm or greater than or equal to about 520 nm) and may be less than or equal to about 560 nm (e.g., less than or equal to about 550 nm or less than or equal to about 540 nm). In the quantum dot light emitting device 10 of an embodiment, the quantum dot light emitting layer 13 or quantum dots may be configured to emit red light and the maximum emission wavelength ($\lambda_{max,L}$) may be in the range of greater than or equal to about 600 nm (e.g., greater than or equal to about 610 nm) and less than or equal to about 670 nm (e.g., less than or equal to about 650 nm or less than or equal to about 640 nm). In the quantum dot light emitting device 10 of an embodiment, the quantum dot light emitting layer 13 or quantum dots may be configured to emit blue light and the maximum emission wavelength ($\lambda_{max,L}$) may be in the range of greater than or equal to about 430 nm (e.g., greater than or equal to about 440 nm or greater than or equal to about 450 nm) and less than or equal to about 480 nm (e.g., less than or equal to about 470 nm or less than or equal to about 465 nm).

The quantum dot may have, for example, a quantum yield of greater than or equal to about 10%, within the above range, for example, greater than or equal to about 20%, greater than or equal to about 30%, greater than or equal to about 50%, greater than or equal to about 60%, greater than or equal to about 70% or greater than or equal to about 90%.

The emission spectrum of the quantum dot may have a relatively narrow full width at half maximum (FWHM). Herein, the FWHM is a width of a wavelength corresponding to half of the maximum emission intensity in the emission spectrum. By applying the quantum dot having an emission spectrum of a relatively narrow FWHM and the quantum dot light emitting layer 13 including the same to the quantum dot light emitting device 10, high color purity (or color gamut) may be advantageously realized.

The FWHM of the quantum dot (or quantum dot light emitting layer 13) may be, for example, less than or equal to about 60 nm, within the above range, for example, less than or equal to about 55 nm, less than or equal to about 52 nm, less than or equal to about 50 nm, less than or equal to about 49 nm, less than or equal to about 48 nm, less than or equal to about 47 nm, less than or equal to about 46 nm, less than or equal to about 45 nm, less than or equal to about 44 nm, less than or equal to about 43 nm, less than or equal to about 42 nm, less than or equal to about 41 nm, less than or equal to about 40 nm, less than or equal to about 39 nm, less than or equal to about 38 nm, less than or equal to about 37 nm, less than or equal to about 36 nm, less than or equal to about 35 nm, less than or equal to about 34 nm, less than or equal to about 33 nm, less than or equal to about 32 nm, less than or equal to about 31 nm, less than or equal to about 30 nm, less than or equal to about 29 nm, or less than or equal to about 28 nm, for example, about 2 nm to about 60 nm, about 2 nm to about 55 nm, about 2 nm to about 50 nm, about 2 nm to about 49 nm, about 2 nm to about 48 nm, about 2 nm to about 47 nm, about 2 nm to about 46 nm, about 2 nm to about 45 nm, about 2 nm to about 44 nm, about 2 nm to about 43 nm, about 2 nm to about 42 nm, about 2 nm to about 41 nm, about 2 nm to about 40 nm, about 2 nm to about 39 nm, about 2 nm to about 38 nm, about 2 nm to about 37 nm, about 2 nm to about 36 nm, about 2 nm to about 35 nm, about 2 nm to about 34 nm, about 2 nm to about 33 nm, about 2 nm to about 32 nm, about 2 nm to about 31 nm, about 2 nm to about 30 nm, about 2 nm to about 29 nm, or about 2 nm to about 28 nm.

For example, the quantum dot may include a Group II-VI semiconductor compound, a Group III-V semiconductor compound, a Group IV-VI semiconductor compound, a Group IV semiconductor, a Group I-III-VI semiconductor compound, a Group I-II-IV-VI semiconductor compound, a Group II-III-V semiconductor compound, or any combination thereof.

The Group II-VI semiconductor compound may be, for example, a binary element compound selected from CdSe, CdTe, ZnS, ZnSe, ZnTe, ZnO, HgS, HgSe, HgTe, MgSe, MgS, and a combination thereof; a ternary element compound selected from CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and a combination thereof; and a quaternary element compound selected from HgZnTeS, CdZnSeS, CdZnSeTe, CdZnSTe, CdHgSeS, CdHgSeTe, CdHgSTe, HgZnSeS, HgZnSeTe, HgZnSTe, and a combination thereof, but is not limited thereto. The Group III-V semiconductor compound may be, for example, a binary element compound selected from GaN, GaP, GaAs, GaSb, AlN, AlP, AlAs, AlSb, InN, InP, InAs, InSb, and a combination thereof; a ternary element compound selected from GaNP, GaNAs, GaNSb, GaPAs, GaPSb, AlNP, AlNAs, AlNSb, AlPAs, AlPSb, InNP, InNAs, InNSb, InPAs, InPSb, and a combination thereof; and a quaternary element compound selected from GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, and a combination thereof, but is not limited thereto. The Group IV-VI semiconductor compound may be, for example, a binary element compound selected from SnS, SnSe, SnTe, PbS, PbSe, PbTe, and a combination thereof; a ternary element compound selected from SnSeS, SnSeTe, SnSTe, PbSeS, PbSeTe, PbSTe, SnPbS, SnPbSe, SnPbTe, and a combination thereof; and a quaternary element compound selected from SnPbSSe, SnPbSeTe, SnPbSTe, and a combination thereof, but is not limited thereto. The Group IV semiconductor may be, for example, a singular element semiconductor selected from Si, Ge, and a combination thereof; and a binary element semiconductor selected from SiC, SiGe, and a combination thereof, but is not limited thereto. The Group I-III-VI semiconductor compound may be, for example, a ternary element compound selected from $AgInS$, $AgInS_2$, $AgInSe_2$, $AgGaS$, $AgGaS_2$, $AgGaSe_2$, $CuInS$, $CuInS_2$, $CuInSe_2$, $CuGaS_2$, $CuGaSe_2$, $CuGaO_2$, $AgGaO_2$, and $AgAlO_2$; a quaternary element compound selected from $AgInGaS_2$, $AgInGaSe_2$, $CuInGaSe$, and $CuInGaS$; or any combination thereof, but is not limited thereto. The Group I-II-IV-VI semiconductor compound may be, for example, selected from CuZnSnSe, CuZnSnS, or any combination thereof, but is not limited thereto. The Group II-III-V semiconductor compound may include, for example, InZnP, but is not limited thereto.

The quantum dot may include the singular element semiconductor, the binary element semiconductor compound, the ternary element semiconductor compound, or the quaternary element semiconductor compound in a substantially uniform concentration or partially different concentration distributions. Each element included in a multi-element compound such as the binary element semiconductor compound, the ternary element semiconductor compound, and the quaternary element semiconductor compound may be present at a uniform or nonuniform concentration in the quantum dot particle. In other words, a chemical formula representing the compound indicates the type of elements included in the compound, but does not limit an element ratio of each element. All the elements included in each compound may have a different element ratio, for example, $AgInGaS_2$ may mean $AgIn_xGa_{1-x}S_2$ ($0 \le x \le 1$).

For example, the quantum dot may include a cadmium (Cd)-free quantum dot. Cadmium (Cd) may cause severe environment/health problems and is a restricted element by Restriction of Hazardous Substances Directive (RoHS) in numerous countries, and thus the non-cadmium-based quantum dot may be effectively and advantageously used. In an embodiment, the quantum dot light emitting layer 13 does not include cadmium. In an embodiment, the quantum dot light emitting layer 13 does not include cadmium, lead, mercury, or any combination thereof.

For example, the quantum dot may include a semiconductor compound including zinc (Zn), and at least one of tellurium (Te) and selenium (Se). For example, the quantum dot may include a Zn-Te semiconductor compound, a Zn-Se semiconductor compound, a Zn-Se-Te semiconductor compound, or a combination thereof. For example, in the Zn-Se-Te semiconductor compound, a mole fraction of tellurium (Te) may be smaller than a mole fraction of selenium (Se). The semiconductor compound may have a maximum emission wavelength in a wavelength region of less than or equal to about 480 nm, for example, about 430 nm to about 480 nm, and may be configured to emit blue light.

For example, the quantum dot may include a semiconductor compound including indium (In) and at least one of zinc (Zn) and phosphorus (P). For example, the quantum dot may include an In-P semiconductor compound, an In-Zn-P semiconductor compound, or a combination thereof. For example, in the In-Zn-P semiconductor compound, a mole ratio of zinc (Zn) to indium (In) may be greater than or equal to about 25:1.

The quantum dot may have a core-shell structure wherein one quantum dot surrounds another quantum dot. For example, the core and the shell of the quantum dot may have an interface, and an element of at least one of the core or the shell in the interface may have a concentration gradient wherein the concentration of the element(s) decreases from the shell toward the core. For example, a material of the shell of the quantum dot has a higher energy bandgap than a material of the core of the quantum dot, and thereby the quantum dot may exhibit a quantum confinement effect.

The quantum dot may have one quantum dot core and a multi-layered quantum dot shell surrounding the core.

Herein, the multi-layered shell has at least two shells wherein each shell may be a single composition, an alloy, the one having a concentration gradient, or a combination thereof.

For example, a shell of a multi-layered shell that is far from the core may have a higher energy bandgap than a shell that is near to the core, and thereby the quantum dot may exhibit a quantum confinement effect.

For example, the quantum dot having a core-shell structure may, for example, include a core including a first semiconductor compound including zinc (Zn), and at least one of tellurium (Te), and selenium (Se), and a shell including a second semiconductor compound disposed on at least a portion of the core and having a different composition from that of the core.

For example, the first semiconductor compound may be a Zn-Se-Te-based semiconductor compound including zinc (Zn), selenium (Se), and tellurium (Te), for example, a Zn-Se-based semiconductor compound including a small amount of tellurium (Te), and for example, a semiconductor compound represented by $ZnSe_{1-x}Te_x$ (where x is greater than 0 and less than or equal to about 0.05).

For example, in the Zn-Se-Te-based first semiconductor compound, a mole fraction of zinc (Zn) may be greater than a mole fraction of selenium (Se), and a mole fraction of selenium (Se) may be greater than a mole fraction of tellurium (Te). For example, in the first semiconductor compound, a mole ratio of tellurium (Te) relative to selenium (Se) may be less than or equal to about 0.05, less than or equal to about 0.049, less than or equal to about 0.048, less than or equal to about 0.047, less than or equal to about 0.045, less than or equal to about 0.044, less than or equal to about 0.043, less than or equal to about 0.042, less than or equal to about 0.041, less than or equal to about 0.04, less than or equal to about 0.039, less than or equal to about 0.035, less than or equal to about 0.03, less than or equal to about 0.029, less than or equal to about 0.025, less than or equal to about 0.024, less than or equal to about 0.023, less than or equal to about 0.022, less than or equal to about 0.021, less than or equal to about 0.02, less than or equal to about 0.019, less than or equal to about 0.018, less than or equal to about 0.017, less than or equal to about 0.016, less than or equal to about 0.015, less than or equal to about 0.014, less than or equal to about 0.013, less than or equal to about 0.012, less than or equal to about 0.011, or less than or equal to about 0.01. For example, in the first semiconductor compound, a mole ratio of tellurium (Te) relative to zinc (Zn) may be less than or equal to about 0.02:1, less than or equal to about 0.019:1, less than or equal to about 0.018:1, less than or equal to about 0.017:1, less than or equal to about 0.016:1, less than or equal to about 0.015:1, less than or equal to about 0.014:1, less than or equal to about 0.013:1, less than or equal to about 0.012:1, less than or equal to about 0.011:1, or less than or equal to about 0.01:1.

The second semiconductor compound may include, for example, a Group II-VI semiconductor compound, a Group III-V semiconductor compound, a Group IV-VI semiconductor compound, a Group IV semiconductor, a Group I-III-VI semiconductor compound, a Group I-II-IV-VI semiconductor compound, a Group II-III-V semiconductor compound, or any combination thereof. Examples of the Group II-VI semiconductor compound, the Group III-V semiconductor compound, the Group IV-VI semiconductor compound, the Group IV semiconductor, the Group I-III-VI semiconductor compound, the Group I-II-IV-VI semiconductor compound, and the Group II-III-V semiconductor compound are the same as described above.

For example, the second semiconductor compound may include zinc (Zn), selenium (Se), and/or sulfur (S). For example, the shell may include ZnSeS, ZnS, ZnSe, or any combination thereof, and may include at least one inner shell disposed near to the core and an outermost shell disposed at the outermost side of the quantum dot, and the inner shell may include ZnSeS or ZnSe and the outermost shell may include ZnS. For example, the shell may have a concentration gradient of one component and, for example, an amount of sulfur (S) may increase as being apart from the core.

For example, a quantum dot having a core-shell structure may include a core including a third semiconductor compound including indium (In) and at least one of zinc (Zn) and phosphorus (P), and a shell disposed on at least a portion of the core and including a fourth semiconductor compound having a composition different from the core.

In the In-Zn-P-based third semiconductor compound, a mole ratio of zinc (Zn) to indium (In) may be greater than or equal to about 25:1. For example, in the In-Zn-P-based third semiconductor compound, the mole ratio of zinc (Zn) to indium (In) may be greater than or equal to about 28:1, greater than or equal to about 29:1, or greater than or equal to about 30:1. For example, in the In-Zn-P-based third semiconductor compound, the mole ratio of zinc (Zn) to indium (In) may be less than or equal to about 55:1, for example less than or equal to about 50:1, less than or equal to about 45:1, less than or equal to about 40:1, less than or equal to about 35:1, less than or equal to about 34:1, less than or equal to about 33:1, or less than or equal to about 32:1.

The fourth semiconductor compound may include, for example, a Group II-VI semiconductor compound, a Group III-V semiconductor compound, a Group IV-VI semiconductor compound, a Group IV semiconductor, a Group I-III-VI semiconductor compound, a Group I-II-IV-VI semiconductor compound, a Group II-III-V semiconductor compound, or any combination thereof. Examples of the Group II-VI semiconductor compound, Group III-V semiconductor compound, Group IV-VI semiconductor compound, Group IV semiconductor, Group I-III-VI semiconductor compound, Group I-II-IV-VI semiconductor compound, and Group II-III-V semiconductor compound are the same as described above.

For example, the fourth semiconductor compound may include zinc (Zn) and sulfur (S) and optionally selenium (Se). For example, the shell may include ZnSeS, ZnS, ZnSe, or any combination thereof. For example, the shell may include at least one inner shell disposed close to the core and an outermost shell disposed at the outermost side of the quantum dot. At least one of the inner shell and the outermost shell may include a fourth semiconductor compound of ZnS, ZnSe, or ZnSeS.

The aforementioned quantum dots are commercially available or may be appropriately synthesized.

In the quantum dot device 10 of an embodiment, the quantum dot(s) may include a first organic ligand on the surface thereof. The first organic ligand may have a hydrophobic moiety. The first organic ligand may be bound to the surface of the quantum dot. The first organic ligand may include $RCOOH$, $RNH_2$, $R_2NH$, $R_3N$, $RSH$, $R_3PO$, $R_3P$, $ROH$, $RC(=O)OR$, $RC(=O)OC(=O)R$, $RPO(OH)_2$, $RHPOOH$, $R_2POOH$, or any combination thereof, wherein each R is each independently a substituted or unsubstituted C1 to C40 aliphatic hydrocarbon group such as a C3 to C40 alkyl or alkenyl, a C1 to C40 substituted or unsubstituted aromatic hydrocarbon group such as a C6 to C40 aryl group, or any combination thereof.

Examples of the first organic ligand may include a thiol compound such as methane thiol, ethane thiol, propane thiol, butane thiol, pentane thiol, hexane thiol, octane thiol, dodecane thiol, hexadecane thiol, octadecane thiol, benzyl thiol, and the like; amines such as methane amine, ethane amine, propane amine, butane amine, pentyl amine, hexyl amine, octyl amine, nonylamine, decylamine, dodecyl amine, hexadecyl amine, octadecyl amine, dimethyl amine, diethyl amine, dipropyl amine, tributylamine, trioctylamine, and the like; a carboxylic acid compound such as methanoic acid, ethanoic acid, propanoic acid, butanoic acid, pentanoic acid, hexanoic acid, heptanoic acid, octanoic acid, dodecanoic acid, hexadecanoic acid, octadecanoic acid, oleic acid, benzoic acid, and the like; a phosphine compound such as methyl phosphine, ethyl phosphine, propyl phosphine, butyl phosphine, pentyl phosphine, octylphosphine, dioctyl phosphine, tributylphosphine, trioctylphosphine, and the like; a phosphine oxide compound such as methyl phosphine oxide, ethyl phosphine oxide, propyl phosphine oxide, butyl phosphine oxide pentyl phosphine oxide, tributylphosphine oxide, octylphosphine oxide, dioctyl phosphine oxide, trioctylphosphine oxide; diphenyl phosphine, triphenyl phosphine compound or an oxide compound thereof; a C5 to C20 alkylphosphinic acid such as hexylphosphinic acid, octylphosphinic acid, dodecanephosphinic acid, tetradecanephosphinic acid, hexadecanephosphinic acid, octadecanephosphinic acid, a C5 to C20 alkyl phosphonic acid such as hexylphosphonic acid, octylphosphonic acid, dodecane phosphonic acid, tetradecane phosphonic acid, hexadecane phosphonic acid, octadecane phosphonic acid; and the like, but are not limited thereto. One or more organic ligands may be used. For example, the quantum dots may include a hydrophobic organic ligand alone or in a mixture.

The quantum dots may include a halogen together with an organic ligand (e.g., C5 or higher or C10 or higher fatty acid compound, e.g., oleic acid) on the surface (hereinafter referred to as "halogen-treated quantum dots"). The content of halogen in halogen-treated quantum dots may be, for example, greater than or equal to about 1 microgram ($\mu$g), greater than or equal to about 1.5 $\mu$g, greater than or equal to about 3 $\mu$g, greater than or equal to about 4 $\mu$g, greater than or equal to about 5 $\mu$g, greater than or equal to about 6 $\mu$g, greater than or equal to about 7 $\mu$g, greater than or equal to about 8 $\mu$g, greater than or equal to about 9 $\mu$g, greater than or equal to about 10 $\mu$g, greater than or equal to about 11 $\mu$g, greater than or equal to about 12 $\mu$g, greater than or equal to about 12.5 $\mu$g, greater than or equal to about 13 $\mu$g, greater than or equal to about 14 $\mu$g, greater than or equal to about 15 $\mu$g, greater than or equal to about 16 $\mu$g, greater than or equal to about 17 $\mu$g, greater than or equal to about 18 $\mu$g, or greater than or equal to about 19 $\mu$g and may be less than about 30 $\mu$g, less than or equal to about 25 $\mu$g, less than or equal to about 20 $\mu$g, less than or equal to about 19.5 $\mu$g, less than or equal to about 19 $\mu$g, less than or equal to about 18 $\mu$g, less than or equal to about 17 $\mu$g, less than or equal to about 15 $\mu$g, less than or equal to about 12.5 $\mu$g, or less than or equal to about 12 $\mu$g per milligram (mg) of the halogen-treated quantum dots, as confirmed by ion chromatography. The halogen may be chlorine.

An example of a method of preparing the halogen-treated quantum dots may include obtaining an organic dispersion including a plurality of quantum dots including a first organic ligand on the surface and a first organic solvent; obtaining a chloride solution including a polar organic solvent miscible with the first organic solvent and a metal halide; and adding the chloride solution to the organic dispersion so that the content of the metal halide may be greater than or equal to about 0.1 weight percent (wt%) and may be less than or equal to about 10 wt% based on a total weight of the quantum dots, and then stirring the resultant dispersion at a temperature of greater than or equal to about 45 °C, for example, greater than or equal to about 50 °C, greater than or equal to about 55 °C, or greater than or equal to about 60 °C and less than or equal to about 150 °C, less than or equal to about 140 °C, less than or equal to about 100 °C, less than or equal to about 90 °C, less than or equal to about 80 °C, or less than or equal to about 70 °C. A volume ratio of the polar organic solvent to the first organic solvent may be less than or equal to about 0.1.

The metal halide (e.g., metal chloride) may include a zinc halide, an indium halide, a gallium halide, a magnesium halide, a lithium halide, or any combination thereof. The first organic solvent may include a substituted or unsubstituted C5 to C40 aliphatic hydrocarbon, a substituted or unsubstituted C6 to C40 aromatic hydrocarbon, a substituted or unsubstituted C3 to C40 alicyclic hydrocarbon, or any combination thereof. The polar organic solvent may include a C1 to C10 alcohol (e.g., methanol, ethanol, propanol, isopropanol, butanol, pentanol, hexanol, heptanol, etc.) or any combination thereof.

The quantum dot light emitting layer 13 may have a single layer or a multilayer structure in which two or more layers are stacked. In the multilayer structure, adjacent layers (e.g., the first quantum dot light emitting layer and the second quantum dot light emitting layer) may have different physical properties and/or compositions. At least one layer of the quantum dot light emitting layers 13 of an embodiment may include a halogen (e.g., chlorine). The quantum dot light emitting layer 13 of an embodiment may exhibit a halogen content that changes in a thickness direction (e.g., varies with thickness).

An example of the quantum dot light emitting layer 13 may include a layer (hereinafter, referred to as a surface-treated first quantum dot light emitting layer or a first layer) including quantum dots and having a surface treated with halogen (e.g., chlorine). A second layer including the halogen-treated quantum dots, a third layer including quantum dots having organic ligands, or a combination thereof, may be disposed on the first layer. The second layer may be disposed between the first layer and the third layer. The organic material (e.g., carbon) content (e.g., concentration) of the first layer may be lower than the organic material content of the second layer. The halogen (e.g., chlorine) content (e.g., concentration) of the first layer may be higher than the halogen content of the second layer. The organic material content of the first layer may be higher than the organic material content of the second layer. The halogen content of the first layer may be lower than the organic material content of the second layer. The organic material content of the quantum dot light emitting layer 13 may be controlled by an appropriate means (post-treatment for the formed layer).

The quantum dot light emitting layer 13 may have a relatively deep HOMO energy level, for example, a HOMO energy level of greater than or equal to about 5.4 eV, for example, greater than or equal to about 5.6 eV, for example, greater than or equal to about 5.7 eV, for example, greater than or equal to about 5.8 eV, for example, greater than or equal to about 5.9 eV, for example, greater than or equal to about 6.0 eV. The HOMO energy level of the quantum dot light emitting layer 13 may be, for example, about 5.4 eV to about 7.0 eV, for example, about 5.4 eV to about 6.8 eV, for example, about 5.4 eV to about 6.7 eV, for example, about 5.4 eV to about 6.5 eV, for example, about 5.4 eV to about 6.3 eV, for example, about 5.4 eV to about 6.2 eV, for example, about 5.4 eV to about 6.1 eV, within the above range, for example, about 5.6 eV to about 7.0 eV, for example, about 5.6 eV to about 6.8 eV, for example, about 5.6 eV to about 6.7 eV, for example, about 5.6 eV to about 6.5 eV, for example, about 5.6 eV to about 6.3 eV, for example, about 5.6 eV to about 6.2 eV, for example, about 5.6 eV to about 6.1 eV, within the above range, for example, about 5.7 eV to about 7.0 eV, for example, about 5.7 eV to about 6.8 eV, for example, about 5.7 eV to about 6.7 eV, for example, about 5.7 eV to about 6.5 eV, for example, about 5.7 eV to about 6.3 eV, for example, about 5.7 eV to about 6.2 eV, for example, about 5.7 eV to about 6.1 eV, within the above range, for example, about 5.8 eV to about 7.0 eV, for example, about 5.8 eV to about 6.8 eV, for example, about 5.8 eV to about 6.7 eV, for example, about 5.8 eV to about 6.5 eV, for example, about 5.8 eV to about 6.3 eV, for example, about 5.8 eV to about 6.2 eV, for example, about 5.8 eV to about 6.1 eV, within the above range, for example, about 6.0 eV to about 7.0 eV, for example, about 6.0 eV to about 6.8 eV, for example, about 6.0 eV to about 6.7 eV, for example, about 6.0 eV to about 6.5 eV, for example, about 6.0 eV to about 6.3 eV, for example, about 6.0 eV to about 6.2 eV.

The quantum dot light emitting layer 13 may have a relatively shallow LUMO energy level, for example, a LUMO energy level of less than or equal to about 3.6 eV, for example, less than or equal to about 3.5 eV, for example, less than or equal to about 3.4 eV, for example, less than or equal to about 3.3 eV, for example, less than or equal to about 3.2 eV, or for example, less than or equal to about 3.0 eV. The LUMO energy level of the quantum dot light emitting layer 13 may be about 2.5 eV to about 3.6 eV, about 2.5 eV to about 3.5 eV, for example, about 2.5 eV to about 3.4 eV, for example, about 2.5 eV to about 3.3 eV, for example, about 2.5 eV to about 3.2 eV, for example, about 2.5 eV to about 3.1 eV, for example, about 2.5 eV to about 3.0 eV, for example, about 2.8 eV to about 3.6 eV, about 2.8 eV to about 3.5 eV, for example, about 2.8 eV to about 3.4 eV, for example, about 2.8 eV to about 3.3 eV, for example, about 2.8 eV to about 3.2 eV, about 3.0 eV to about 3.6 eV, about 3.0 eV to about 3.5 eV, or for example, about 3.0 eV to about 3.4 eV.

The quantum dot light emitting layer 13 may have an energy bandgap of about 2.4 eV to 3.9 eV. Within the above range, it may have an energy bandgap, for example, about 2.5 eV to about 3.8 eV, within the above range, for example, about 2.6 eV to about 3.7 eV.

A thickness of the quantum dot light emitting layer 13 may be less than or equal to about 200 nm, for example, about 5 nm to about 200 nm, about 10 nm to about 200 nm, about 20 nm to about 150 nm, about 20 nm to about 100 nm, about 30 nm to about 100 nm, about 20 nm to about 80 nm, or about 30 nm to about 80 nm.

The hole auxiliary layers 14 and 15 may include a first hole auxiliary layer 14 and a second hole auxiliary layer 15. The first hole auxiliary layer 14 and the second hole auxiliary layer 15 may be located between the anode 11 and the quantum dot light emitting layer 13 to improve electrical performance between the anode 11 and the quantum dot light emitting layer 13. The first hole auxiliary layer 14 may be located closer to the anode 11 between the anode 11 and the quantum dot light emitting layer 13, and the second hole auxiliary layer 15 may be located closer to the quantum dot light emitting layer 13 between the anode 11 and the quantum dot light emitting layer 13. The first hole auxiliary layer 14 and the second hole auxiliary layer 15 may increase the injection and transport of holes from the anode 11 to the quantum dot light emitting layer 13. For example, the first hole auxiliary layer 14 may be a hole injection layer that increases hole injection from the anode 11, and the second hole auxiliary layer 15 may be a hole transport layer that increases hole transport to the quantum dot light emitting layer 13. At least one of the first hole auxiliary layer 14 and the second hole auxiliary layer 15 may have electron blocking characteristics.

The first hole auxiliary layer 14 and the second hole auxiliary layer 15 may have a relatively high HOMO energy level to match the HOMO energy level of the quantum dot light emitting layer 13. Accordingly, the mobility of holes passing through the first hole auxiliary layer 14 and the second hole auxiliary layer 15 and being transferred to the quantum dot light emitting layer 13 may be increased.

The HOMO energy level of the first hole auxiliary layer 14 and the second hole auxiliary layer 15 may be equal to or smaller than the HOMO energy level of the quantum dot light emitting layer 13 by less than or equal to about 1.0 eV. For example, a difference in HOMO energy level between the second hole auxiliary layer 15 and the quantum dot light emitting layer 13 may be about 0 eV to about 1.0 eV, within the above range, for example, about 0.01 eV to about 0.8 eV, for example, about 0.01 eV to about 0.7 eV, about 0.01 eV to about 0.5 eV, for example, about 0.01 eV to about 0.4 eV, for example, about 0.01 eV to about 0.3 eV, for example, about 0.01 eV to about 0.2 eV, for example, about 0.01 eV to about 0.1eV.

The HOMO energy level of the first hole auxiliary layer 14 and the second hole auxiliary layer 15 may be, for example, greater than or equal to about 5.0 eV, for example, greater than or equal to about 5.2eV, for example, greater than or equal to about 5.4 eV, for example greater than or equal to about 5.6 eV, for example greater, than or equal to about 5.8 eV.

For example, the HOMO energy levels of the first hole auxiliary layer 14 and the second hole auxiliary layer 15 may be about 5.0 eV to about 7.0 eV, within the above range, for example, about 5.2 eV to about 6.8 eV, about 5.4 eV to 6.8 eV, for example, about 5.4 eV to 6.7 eV, for example, about 5.4 eV to about 6.5 eV, for example, about 5.4 eV to about 6.3 eV, for example, about 5.4 eV to about 6.2 eV, for example, about 5.4 eV to about 6.1 eV, for example, about 5.6 eV to about 7.0 eV, for example, about 5.6 eV to about 6.8 eV, for example, about 5.6 eV to about 6.7 eV, for example, about 5.6 eV to about 6.5 eV, for example, about 5.6 eV to about 6.3 eV, for example, about 5.6 eV to about 6.2 eV, for example, about 5.6 eV to about 6.1 eV, for example, about 5.8 eV to about 7.0 eV, for example, about 5.8 eV to about 6.8 eV, for example, about 5.8 eV to about 6.7 eV, for example, about 5.8 eV to about 6.5 eV, for example, about 5.8 eV to about 6.3 eV, for example, about 5.8 eV to about 6.2 eV, for example, about 5.8 eV to about 6.1 eV.

The first hole auxiliary layer 14 and the second hole auxiliary layer 15 may include one or more hole transport materials, and the hole transport materials may include, for example, an organic material, an inorganic material, an organic/inorganic material, or any combination thereof, for example, N,N,N',N'-tetrakis(4-methoxyphenyl)-benzidine (TPD), N,N'-bis(1-naphthyl)-N,N'-diphenyl-(1,1'-biphenyl)-4,4'-diamine (NPD), 4,4',4"-tris[phenyl(m-tolyl)amino]triphenylamine) (m-MTDATA), 4,4',4"-tris(N-carbazolyl)-triphenylamine, TCTA), 1,1-bis[ (di-4-tolylamino)phenyl]cyclohexane (TAPC), N2,N7-di(naphthalen-1-yl)-9,9-dioctyl-N2,N7-diphenyl-9H-fluorene-2,7-diamine (NPB), 2,7-bis(carbazol-9-yl)-9,9-spirobifluorene (Spiro-2CBP), 2,2',7,7'-Tetra(N,N-di-p-tolyl)amino-9,9-spirobifluorene (Spiro-TTB), 2,2',7,7'-tetrakis(N, N-diphenylamino)-9,9-spirobifluorene (Spiro-TAD), 1,1-bis[(di-4-tolylamino)phenyl]cyclohexane (TAPC), 4,4'-Bis(N-carbazolyl)-1,1'-biphenyl (CBP), 4,4',4"-tris[2-naphthyl(phenyl)amino]triphenylamine (2-TNATA), 1,3,5-tris (4-diphenylaminophenyl)benzene (TDAPB), poly(9,9-dioctyl-fluorene-co-N-(4-butylphenyl)-diphenylamine) (TFB), polyarylamine, poly(N-vinylcarbazole), poly (3,4-ethylenedioxythiophene) (PEDOT), poly(3,4-ethylenedioxythiophene) polystyrene sulfonate (PEDOT:PSS), polyaniline, polypyrrole, Spiro-PMATD, triphenylbismuth dichloride (TPBC), poly(triaryl amine) (PTAA), poly(3-hexylthiophene-2,5-diyl) (P3HT), poly[3-(5-carboxypentyl)thiophene-2,5-diyl] (P3CPenT), poly [2,6-(4,4-bis-(2-ethylhexyl)-4H-cyclopenta[2,1-b;3,4-b']dithiophene)-alt-4,7 (2,1,3-benzothiadiazole)](PCPDT-t), poly(2,3-dihydrothieno[3,4-b][1,4]dioxane-5,7-diyl)(PEDOT-S), polyferric sulfate (PFS), CuI, $Cu_2O$, CuO, CuS, NiOx, $CuGaO_2$, CuPc, CuSCN, $MoO_x$, $MoS_2$, $VO_x$, $CoO_x$, graphene oxide, or any combination thereof, but is not limited thereto.

The electron auxiliary layer 16 may improve electrical performance between the cathode 12 and the quantum dot light emitting layer 13. For example, it is possible to increase the transport of electrons from the cathode 12 to the quantum dot light emitting layer 13 and effectively block the reverse injection of holes from the quantum dot light emitting layer 13 to the cathode 12. The electron auxiliary layer 16 may have one layer or two or more layers. The electron auxiliary layer 16 may include one or more electronic auxiliary materials, and the electronic auxiliary material may be an electron transport material, an electron injection material, or a combination thereof.

A LUMO energy level of the electronic auxiliary material may be deeper than a LUMO energy level of the quantum dot light emitting layer 13 (quantum dots included in the quantum dot light emitting layer). A difference between the LUMO energy level of the electronic auxiliary material and the LUMO energy level of the quantum dot light emitting layer 13 (quantum dots included in the quantum dot light emitting layer) may be less than or equal to about 2.5 eV, less than or equal to about 2.3 eV, less than or equal to about 2.0 eV, or less than or equal to about 1.8 eV. The LUMO energy level of the electronic auxiliary material may be each, for example, about 2.5 eV to about 4.8 eV, and within the above range, for example, about 2.6 eV to about 4.6 eV or about 2.7 eV to about 4.5 eV.

A HOMO energy level of the electronic auxiliary material may be deeper than a HOMO energy level of the quantum dot light emitting layer 13 (quantum dots included in the quantum dot light emitting layer). For example, the HOMO energy level of the electronic auxiliary material may be deeper than the HOMO energy level of the quantum dot light emitting layer 13 (quantum dots included in the quantum dot light emitting layer) by greater than or equal to about 0.2 eV, greater than or equal to about 0.5 eV, greater than or equal to about 0.8 eV, greater than or equal to about 1.0 eV, greater than or equal to about 1.2 eV, or greater than or equal to about 1.5 eV, for example, about 0.2 eV to about 3.0 eV, about 0.5 eV to about 3.0 eV, about 0.8 eV to about 3.0 eV, about 1.0 eV to about 3.0 eV, about 1.2 eV to about 3.0 eV, or about 1.5 eV to about 3.0 eV.

For example, the HOMO energy level of the electronic auxiliary material may be, for example, about 5.6 eV to about 8.5 eV, within the above range, about 5.8 eV to about 8.2 eV, about 6.0 eV to about 8.0 eV, about 6.2 eV to about 8.0 eV, about 6.5 eV to about 8.0 eV, about 6.8 eV to about 8.0 eV, about 7.0 eV to about 8.0 eV, about 7.2 eV to about 7.9 eV, or about 7.3 eV to about 7.8 eV.

For example, the energy bandgap of the electronic auxiliary material may be greater than or equal to about 2.0 eV and may be less than about 4.0 eV, and within the above range, about 2.1 eV to about 3.9 eV, about 2.3 eV to about 3.8 eV, or about 2.5 eV to about 3.8 eV.

For example, the electronic auxiliary material may include inorganic nanoparticles. The inorganic nanoparticles may be, for example, oxide nanoparticles, for example, metal oxide nanoparticles such as metal oxide nanoparticles including two or more types of metals. The inorganic nanoparticles may be three-dimensional nanoparticles with an average particle diameter of several nanometers, and may be, for example, an inorganic semiconductor, for example, an n-type inorganic semiconductor.

As an example, the inorganic nanoparticles may be alkaline-earth metal containing oxide nanoparticles. The alkaline-earth metal may be selected from, for example, beryllium (Be), magnesium (Mg), calcium (Ca), barium (Ba), strontium (Sr), radium (Ra), or any combination thereof. The alkaline-earth metal may include, for example, magnesium (Mg). The alkaline-earth metal containing oxide nanoparticles may further include one or more metals other than the alkaline-earth metal, and may include for example at least one selected from zinc (Zn), cobalt (Co), nickel (Ni), gallium (Ga), zirconium (Zr), tungsten (W), titanium (Ti), tantalum (Ta), tin (Sn), and hafnium (Hf).

As an example, the alkaline-earth metal containing oxide nanoparticles may include an alkaline-earth metal and zinc (Zn). In the alkaline-earth metal containing oxide nanoparticles, the alkaline-earth metal may have a smaller content of than the zinc (Zn), for example, the alkaline-earth metal may be included in an amount of about 0.01 at% to about 30 at% or about 0.01 at% to about 20 at%, about 1 at% to about 19 at%, about 5 at% to about 18 at%, about 10 at% to about 17 at%, or about 11 at% to about 16 at% based on a total number of metal atoms included in the alkaline-earth metal containing oxide nanoparticles, that is, the total atom number of the alkaline-earth metal and the zinc.

For example, the alkaline-earth metal containing oxide nanoparticles may be expressed as $Zn_{1-x}Q_xO$ (wherein Q is Be, Mg, Ca, Ba, Sr, Re, or any combination thereof, and $0<x<0.5$). For example, Q may include Mg. Alternatively or additionally, $0.01 \leq x \leq 0.3$, $0.01 \leq x \leq 0.2$, $0.01 \leq x \leq 0.19$, $0.05 \leq x \leq 0.18$, $0.10 \leq x \leq 0.17$, or $0.11 \leq x \leq 0.16$.

The alkaline-earth metal containing oxide nanoparticles may be, for example, synthesized in a sol-gel method or a solution-precipitation method, wherein during the synthesis process, a conversion process from the metal precursor to a metal hydroxide and a growth rate of the metal precursor into the oxide nanoparticles may be effectively controlled to reduce defects inside the oxide nanoparticles, thereby allowing them to have a modified and improved shape and size.

For example, the alkaline-earth metal containing oxide nanoparticles may uniformly grow to have a smaller and more spherical shape, for example, satisfy a valley depth (VD) represented by Relational Equation 1.

## Relational Equation 1

$$0.075 \leq 1 - (Abs_{valley} / Abs_{peak}) \leq 0.095$$

In Relational Equation 1,

$Abs_{peak}$ is an absorbance at the peak of the UV-Vis absorption spectrum, and
$Abs_{valley}$ is an absorbance at the lowest point of the valley adjacent to the peak of the UV-Vis absorption spectrum.

In Relational Equation 1, the valley may be a region indicating a valley-shaped absorbance change near to a peak in the UV-Vis absorption spectrum, and $Abs_{valley}$ may be absorbance at the lowest point (inflection point). For example, in a normalized UV-Vis absorption spectrum where the absorbance at the peak of the UV-Vis absorption spectrum is normalized to 1, the $Abs_{valley}$ may be defined as a difference between absorbance (maximum absorbance) at the peak and absorbance (minimum absorbance) at the lowest point of the valley. For example, in the UV-Vis absorption spectrum, a peak wavelength may be about 250 nm to about 340 nm, and within the range, about 270 nm to about 330 nm or about 280 nm to about 330 nm.

The valley depth (VD) expressed by Relational Equation 1 may be used to evaluate uniformity of the nanoparticles, wherein the higher valley depth (VD) may be predicted to result in the higher uniformity of the nanoparticles.

For example, the valley depth (VD) may satisfy Relational Equation 1a.

## Relational Equation 1a

$$0.078 \leq 1 - (Abs_{valley} / Abs_{peak}) \leq 0.092$$

For example, the valley depth (VD) may satisfy Relational Equation 1b.

## Relational Equation 1b

$$0.079 \leq 1 - (Abs_{valley} / Abs_{peak}) \leq 0.090$$

For example, the valley depth (VD) may satisfy Relational Equation 1c.

## Relational Equation 1c

$$0.080 \leq 1 - (Abs_{valley} / Abs_{peak}) \leq 0.088$$

For example, the valley depth (VD) may satisfy Relational Equation 1d.

## Relational Equation 1d

$$0.080 \leq 1 - (Abs_{valley} / Abs_{peak}) \leq 0.086$$

The average circularity (C) of the alkaline-earth metal-containing oxide nanoparticles is an average value obtained by dividing the area of the oxide nanoparticles by the square of the circumference and multiplying by $4\pi$, and may be a criterion indicating whether the shape of the oxide nanoparticles is close to a perfect sphere. As the average circularity (C) is closer to 1, the more the oxide nanoparticles may be close to a perfect spherical shape.

For example, an average particle diameter of the alkaline-earth metal containing oxide nanoparticles may be less than or equal to about 2.2 nm and within the range, about 1.2 nm to about 2.2 nm, about 1.2 nm to about 2.1 nm, about 1.2 nm to about 2.0 nm, about 1.4 nm to about 2.2 nm, about 1.4 nm to about 2.1 nm, about 1.4 nm to about 2.0 nm, about 1.5 nm to about 2.2 nm, about 1.5 nm to about 2.1 nm, or about 1.5 nm to about 2.0 nm. A standard deviation of the average particle diameter may be less than or equal to about 0.70, for example, about 0.10 to about 0.70 or about 0.20 to about 0.65.

For example, the average circularity of the alkaline-earth metal containing oxide nanoparticles may be greater than or equal to about 0.70 and within the range, about 0.70 to about 1.00, about 0.70 to about 0.95, or about 0.70 to about 0.90, about 0.71 to about 0.89, about 0.72 to about 0.88, or about 0.73 to about 0.87. A standard deviation of the average circularity may be less than or equal to about 0.10, for example, about 0.001 to about 0.10.

For example, the alkaline-earth metal containing oxide nanoparticles may form relatively large aggregates. For example, an average particle diameter of the aggregates of the alkaline-earth metal containing oxide nanoparticles, which is measured by dynamic light scattering (DLS), may be about 6 nm to about 15 nm and within the range, about 8 nm to about 15 nm, about 8 nm to about 14 nm or about 10 nm to about 13 nm.

Thus, the alkaline-earth metal containing oxide nanoparticles with modified and improved shapes and sizes, which are obtained by controlling a growth rate of oxide nanoparticles during the synthesis, compared with relatively large and non-uniform alkaline-earth metal containing oxide nanoparticles, may have strongly and uniformly bonded surface ligands, thereby improving electrical characteristics of the electron auxiliary layer 16 including the alkaline-earth metal containing oxide nanoparticles.

A thickness of the electron auxiliary layer 16 may be, for example, about 5 nm to about 100 nm and, within the range, about 10 nm to about 80 nm, about 15 nm to about 80 nm, about 15 nm to about 60 nm, or about 20 nm to about 50 nm.

Hereinafter, a method of manufacturing the aforementioned quantum dot light emitting device 10 is illustrated.

An example of the method of manufacturing the aforementioned quantum dot light emitting device 10 according to some embodiments includes forming the anode 11 on a substrate (not shown), sequentially forming the hole auxiliary layers 14 and 15 on the anode 11, forming the quantum dot light emitting layer 13 on the hole auxiliary layer 15, forming the electron auxiliary layer 16 on the quantum dot light emitting layer 13, and forming the cathode 12 on the electron auxiliary layer 16.

The forming of the hole auxiliary layers 14 and 15, the forming of the quantum dot light emitting layer 13, and the forming of the electron auxiliary layer 16 may each include a solution process, for example, spin coating, slit coating, inkjet printing, nozzle printing, spraying, doctor blade coating, or a combination thereof, but is not limited thereto.

At least a portion of each process of the forming of the hole auxiliary layers 14 and 15, the forming of the quantum dot light emitting layer 13, and the forming of the electron auxiliary layer 16 may further include optionally drying, heat treating after the solution process, or a combination thereof, and the heat-treating may be performed, for example, at about 50 °C to about 300 °C for about 1 minute to about 10 hours, but the present disclosure is not limited thereto.

As an example, the forming of the electron auxiliary layer 16 may include synthesizing the aforementioned alkaline-earth metal containing oxide nanoparticles, dispersing the synthesized alkaline-earth metal containing oxide nanoparticles in a dispersion medium to prepare an alkaline-earth metal containing oxide nanoparticle dispersion, and coating the alkaline-earth metal containing oxide nanoparticles dispersion on the quantum dot light emitting layer 13.

The synthesis of the alkaline-earth metal containing oxide nanoparticles may be, for example, performed in a sol-gel method or a solution-precipitation method, wherein a dispersion medium may be, for example, water; alcohols such as methanol, ethanol, propanol, or butanol; or any combination thereof, but is not limited thereto.

For example, the synthesis of the alkaline-earth metal containing oxide nanoparticles may include preparing a precursor dispersion including an alkaline-earth metal precursor, preparing a basic reagent solution containing a basic reagent, and dropping the basic reagent solution dropwise into the precursor dispersion at a controlled speed to grow alkaline-earth metal containing oxide nanoparticles with modified and improved shapes and sizes.

In addition to the alkaline-earth metal precursor, the precursor dispersion may further include a metal precursor including other metals except for the alkaline-earth metal, for example, at least one selected from a zinc precursor, a cobalt precursor, a nickel precursor, a gallium precursor, a zirconium precursor, a tungsten precursor, a titanium precursor, a tantalum precursor, a tin precursor, and a hafnium precursor, for example, further include a zinc precursor. For example, a ratio of supplying the alkaline-earth metal precursor and the zinc precursor may be adjusted by taking into consideration an atom ratio of alkaline-earth metal and zinc in the alkaline-earth metal containing oxide nanoparticles, for example, more of the zinc precursor may be included than the alkaline-earth metal precursor. For example, the amount of the alkaline-earth metal precursor may be about 0.01 to about 30 mol%, about 0.01 to about 20 mol%, about 1 to about 19 mol%, about 5 to about 18 mol%, about 10 to about 17 mol%, or about 11 to about 16 mol%, based on the total mole number of the alkaline-earth metal precursor and the zinc precursor.

The basic reagent may include an inorganic alkali hydroxide, for example, CsOH, RbOH, KOH, NaOH, LiOH, or any combination thereof. The basic reagent may be prepared as a basic reagent solution, for example, by dissolving the basic reagent in: water; alcohols such as methanol, ethanol, propanol, or butanol; or any combination thereof.

The basic reagent solution may be injected dropwise into the precursor dispersion at a controlled speed. Herein, the injection at a controlled speed may refer to providing drop by drop at a constant speed to the precursor dispersion, for example, slowly dropping at a speed of less than or equal to about 1.5 mmol/min and within the range, about 0.1 mmol/min to about 1.5 mmol/min, about 0.2 mmol/min to about 1.2 mmol/min, about 0.3 mmol/min to about 1.2 mmol/min, about 0.4 mmol/min to about 1.2 mmol/min, about 0.1 mmol/min to about 1.0 mmol/min, about 0.2 mmol/min to about 1.0 mmol/min, about 0.3 mmol/min to about 1.0 mmol/min, about 0.4 mmol/min to about 1.0 mmol/min, about 0.1 mmol/min to about 0.8 mmol/min, about 0.2 mmol/min to about 0.8 mmol/min, about 0.3 mmol/min to about 0.8 mmol/min, or about 0.4 mmol/min to about 0.8 mmol/min.

In this way, the drop by drop addition of the basic reagent to the precursor dispersion at a controlled speed may effectively control a conversion process from the alkaline-earth metal precursor to alkaline-earth metal hydroxide and a growth rate of the alkaline-earth metal precursor to the alkaline-earth metal containing oxide nanoparticles and thus effectively reduce defects inside the oxide nanoparticles, thereby obtaining alkaline-earth metal oxide nanoparticles with modified and improved shapes and sizes. For example, the obtained alkaline-earth metal oxide nanoparticles may have smaller size and higher uniformity, and may satisfy Relational Equation 1.

The aforementioned quantum dot light emitting device 10 may be applied to various electronic devices such as, for example, a display device or a lighting device. For example, the aforementioned quantum dot light emitting device 10 may be applied to various electronic devices requiring light emission, for example, may be applied to various electronic devices such as a display device such as a television (TV), a monitor, a computer, laptop, a mobile, etc., or a lighting device such as a light source.

Hereinafter, the embodiments are illustrated in more detail with reference to examples. However, these examples are exemplary, and the scope of claims is not limited thereto.

Preparation of Quantum Dot

Preparation Example 1

1. Synthesis of Core Quantum Dot

Selenium (Se) and tellurium (Te) are respectively dispersed in trioctylphosphine (TOP) to prepare a 2 molarity (M) Se/TOP stock solution and a 0.1 M Te/TOP stock solution. In a reactor containing trioctylamine, 0.125 mmol of zinc acetate is combined with oleic acid and then heated at 120 °C under vacuum. After 1 hour, an atmosphere in the reactor is substituted with nitrogen.

After heating the reactor to 300 °C, the Se/TOP stock solution and the Te/TOP stock solution in a Te/Se mole ratio of 1/20 is rapidly injected thereinto. When a reaction is completed, after rapidly cooling the reaction solution to room temperature, acetone is added thereto and then centrifuged to obtain precipitates, and the precipitates are dispersed in toluene, obtaining ZnSeTe quantum dot dispersion.

2. Synthesis of Core-shell Quantum Dot

In a flask containing trioctylamine, 1.8 mmol of zinc acetate is combined with oleic acid and then vacuum-treated at 120 °C for 10 minutes. The flask is internally substituted with nitrogen ($N_2$) and heated to 180 °C. Subsequently, the above-obtained ZnSeTe quantum dot dispersion is rapidly injected thereto, and 1.2 mole of Se/TOP and 1.8 mole of Zn oleate are injected thereinto and the temperature is raised to 340 °C to form a ZnSe quantum dot shell on the surface of the ZnSeTe quantum dots. Subsequently, 2.8 mole of S/TOP and 3.6 mole of Zn oleate are additionally injected thereinto to perform a reaction and form a ZnS quantum dot shell on the ZnSe quantum dot shell. Subsequently, nanocrystals obtained after the reaction are dispersed in toluene to obtain ZnSeTe/ZnSe/ZnS core-shell quantum dot dispersion.

3. Surface Exchange Reaction

Zinc chloride is dissolved in ethanol, obtaining a zinc chloride solution at a concentration of 10 wt%. 0.01 milliliter (mL) of the zinc chloride solution is added to the obtained ZnSeTe/ZnSe/ZnS core-shell quantum dot dispersion and then stirred at 60 °C for 30 minutes to perform a surface exchange reaction. After the reaction, ethanol is added thereto to induce precipitation, and precipitates therefrom are centrifuged, which is several times repeated to obtain halogenated (halogen-treated) ZnSeTe/ZnSe/ZnS core-shell quantum dots.

4. Preparation of Quantum Dot Dispersion

The obtained ZnSeTe/ZnSe/ZnS core-shell quantum dot is precipitated with ethanol, recovered through centrifugation, and dispersed in cyclohexylbenzene or octane to prepare quantum dot dispersion.

Preparation of Oxide Nanoparticles

Preparation Example 2

0.9 mmol of magnesium acetate tetrahydrate, 5.1 mmol of zinc acetate dihydrate, and 75 mL of dimethylsulfoxide are added to a reactor and then stirred under $N_2$ environment to prepare a precursor dispersion. Separately therefrom, CsOH is dissolved in ethanol at a concentration of 0.4 M to prepare a basic reagent solution. Subsequently, the basic reagent solution is added dropwise to the precursor dispersion at a rate of 0.4 mmol/min while being stirred. This process takes for 60 minutes. An alkali environment with pH of about 8 to 12 is made by the dropwise addition of the basic reagent solution. Subsequently, the resultant is additionally stirred for 60 minutes at room temperature to obtain grown $Zn_{0.85}Mg_{0.15}O$ nanoparticles.

The grown $Zn_{0.85}Mg_{0.15}O$ nanoparticles and ethyl acetate in a volume ratio of 1:9 are centrifuged and then dispersed in ethanol at a concentration of 1 wt% to obtain an alkaline-earth metal oxide nanoparticle dispersion.

Preparation Example 3

Alkaline-earth metal oxide nanoparticle dispersion is obtained in the same manner as in Preparation Example 2 except that the $Zn_{0.85}Mg_{0.15}O$ nanoparticles are obtained by adding the basic reagent solution dropwise to the precursor dispersion at a rate of 0.8 mmol/min.

Comparative Preparation Example 1

0.9 mmol of magnesium acetate tetrahydrate, 5.1 mmol of zinc acetate dihydrate, and 75 mL of dimethylsulfoxide are added to a reactor and then stirred under a $N_2$ environment to prepare a precursor dispersion. Separately, CsOH is dissolved in ethanol at a concentration of 0.4 M to prepare a basic reagent solution. Subsequently, the basic reagent solution is sprayed to the precursor dispersion. An alkali environment with pH of about 8 to 12 is made by the spraying of the basic reagent solution. Subsequently, the resultant is additionally stirred for 60 minutes, while maintaining room temperature to obtain grown $Zn_{0.85}Mg_{0.15}O$ nanoparticles.

The grown $Zn_{0.85}Mg_{0.15}O$ nanoparticles and ethyl acetate in a volume ratio of 1:9 are centrifuged and then dispersed in ethanol at a concentration of 1 wt% to obtain an alkaline-earth metal oxide nanoparticle dispersion.

Comparative Preparation Example 2

9.00 mmol of zinc acetate dihydrate and 90 mL of dimethylsulfoxide are added to a reactor and then stirred under a $N_2$ environment to prepare a precursor dispersion. Separately, CsOH is dissolved in ethanol at a concentration of 0.4 M to prepare a basic reagent solution. Subsequently, the basic reagent solution is added dropwise to the precursor dispersion at a rate of 0.5 mmol/min. An alkali environment with pH of about 8 to 12 is made by the dropwise addition of the basic reagent solution. Subsequently, the resultant is additionally stirred for 60 minutes, while maintaining room temperature to obtain grown ZnO nanoparticles.

The grown ZnO nanoparticles and ethyl acetate in a volume ratio of 1:9 are centrifuged and then dispersed in ethanol at a concentration of 1 wt% to obtain a ZnO nanoparticle dispersion.

Evaluation I

The average particle size and morphology of alkaline-earth metal oxide nanoparticles according to Preparation Examples 2 and 3, and Comparative Preparation Example 1 are evaluated.

The average particle size of alkaline-earth metal oxide nanoparticles is evaluated using a UT F30 Tecnai electron microscope.

The average circularity of alkaline-earth metal oxide nanoparticles is calculated based on values obtained from TEM images and specifically, is an average value obtained by diving an area of each of the alkaline-earth metal oxide nanoparticles by a square of its circumference and multiplying by $4\pi$.

The average particle diameter of aggregates of alkaline-earth metal oxide nanoparticles is evaluated by dynamic light scattering (DLS).

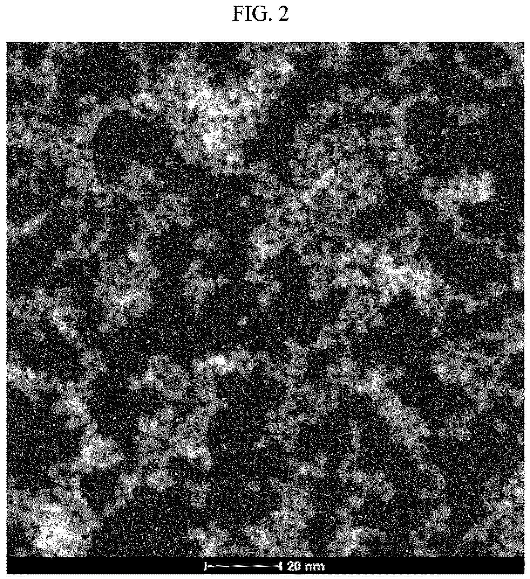

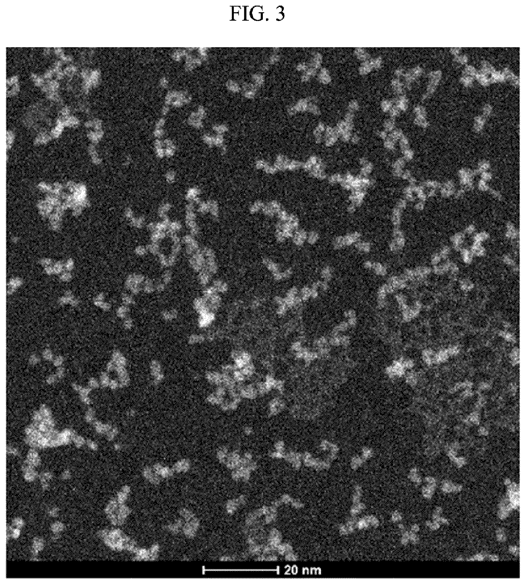

The results are shown in Tables 1 and 2, and FIGS. 2 and 3.

FIG. 2 is a TEM photograph of the alkaline-earth metal oxide nanoparticles according to Preparation Example 3, and FIG. 3 is a TEM photograph of the alkaline-earth metal oxide nanoparticles according to Comparative Preparation Example 1.

Table 1

| | Average particle diameter of alkaline-earth metal oxide nanoparticle (nm) | Average circularity of alkaline-earth metal oxide nanoparticle |
| --- | --- | --- |
| Preparation Example 2 | 1.94 | 0.745 |
| Comparative Preparation Example 1 | 2.44 | 0.696 |

Table 2

| | Average particle diameter (A, nm) of aggregates measured by DLS |
| --- | --- |
| Preparation Example 2 | 12.2 |
| Preparation Example 3 | 11.6 |
| Comparative Preparation Example 1 | 5.8 |

Referring to FIGS. 2 and 3 and Tables 1 and 2, the alkaline-earth metal oxide nanoparticles included in the alkaline-earth metal oxide nanoparticle dispersion according to Preparation Examples 2 and 3 more uniformly grow than the alkaline-earth metal oxide nanoparticles included in the alkaline-earth metal oxide nanoparticle dispersion according to Comparative Preparation Example 1.

Evaluation II

The alkaline-earth metal oxide nanoparticles according to Preparation Examples 2 and 3, and Comparative Preparation Example 1 are respectively subjected to a UV-Vis spectroscopy analysis.

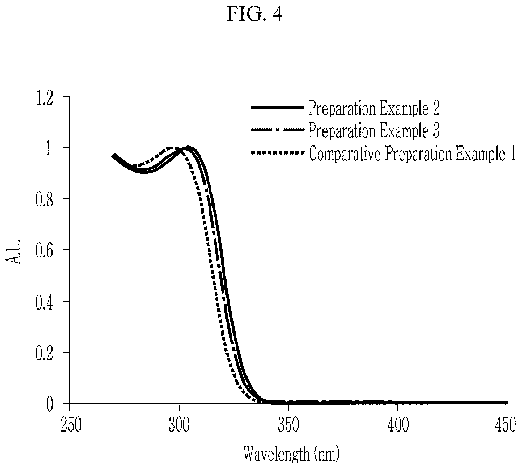

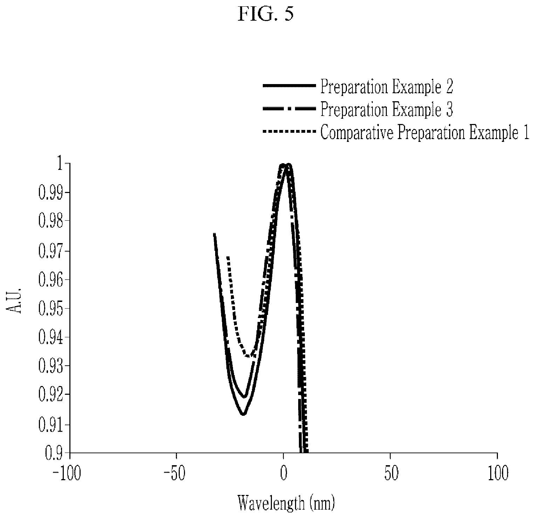

The results are shown in FIGS. 4 and 5, and Table 3.

FIG. 4 is a graph showing the normalized UV-Vis absorption spectrum of the alkaline-earth metal oxide nanoparticles according to Preparation Examples 2 and 3, and Comparative Preparation Example 1; and FIG. 5 is graph of an enlargement of the valley area of the UV-Vis absorption spectrum of FIG. 4. In FIG. 5, a peak wavelength of FIG. 4 is shown as 0 nm wavelength.

Table 3

|  | Valley Depth (VD) |
|---|---|
| Preparation Example 2 | 0.086 |
| Preparation Example 3 | 0.080 |
| Comparative Preparation Example 1 | 0.072 |
| * Valley Depth (VD): 1 - ($Abs_{valley}$ / $Abs_{peak}$) * $Abs_{peak}$ is an absorbance at the peak of the UV-Vis absorption spectrum * $Abs_{valley}$ is an absorbance at the lowest point of the valley adjacent to the peak of the UV-Vis absorption spectrum | |

Referring to FIGS. 4 and 5 and Table 3, the alkaline-earth metal oxide nanoparticles according to Preparation Examples 2 and 3 have a higher valley depth in a valley region of a UV-Vis spectrum than the alkaline-earth metal oxide nanoparticles according to Comparative Preparation Example 1, which confirms that the alkaline-earth metal oxide nanoparticles of Preparation Examples 2 and 3 more uniformly grow than the alkaline-earth metal oxide nanoparticles of Comparative Preparation Example 1.

Evaluation III

A growth rate of alkaline-earth metal oxide nanoparticles according to dropwise addition of a basic reagent solution is evaluated.

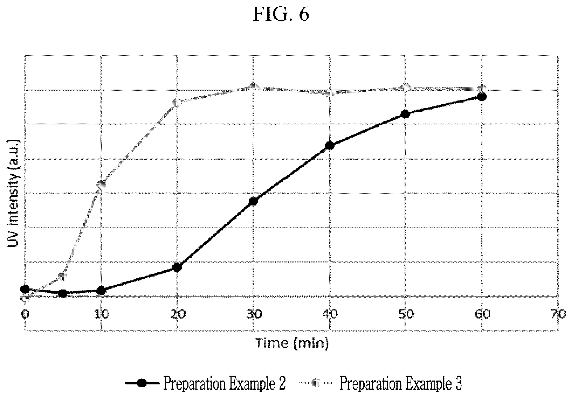

FIG. 6 is a graph showing UV-Vis spectra according to the dropping time in minutes of the basic reagent solution during the synthesis of alkaline-earth metal oxide nanoparticles according to Preparation Examples 2 and 3.
Referring to FIG. 6, the alkaline-earth metal oxide nanoparticles according to Preparation Examples 2 and 3 gradually grow according to the dropwise addition of the basic reagent solution during the synthesis, and thus it is confirmed that a growth rate of the particles may be controlled according to a dropping rate of the basic reagent solution.

Manufacturing of Sample Device

Example 1

The quantum dot dispersion according to Preparation Example 1 is spin-coated on a glass substrate with an ITO electrode and then heat-treated at 80 °C for 30 minutes to form a 28 nm-thick quantum dot light emitting layer. Subsequently, on the quantum dot light emitting layer, the alkaline-earth metal oxide nanoparticle dispersion according to Preparation Example 2 is spin-coated at 80 °C for 30 minutes to form a 20 nm-thick electron auxiliary layer, thereby manufacturing a sample device.

Example 2

A sample device is manufactured in the same manner as in Example 1 except that the alkaline-earth metal oxide nanoparticle dispersion according to Preparation Example 3 is used instead of the alkaline-earth metal oxide nanoparticle dispersion according to Preparation Example 2.

Comparative Example 1

A sample device was manufactured in the same manner as in Example 1 except that the alkaline-earth metal oxide nanoparticle dispersion according to Comparative Preparation Example 1 is used instead of the alkaline-earth metal oxide nanoparticle dispersion according to Preparation Example 2.

Evaluation IV

The photoluminescence life-span characteristics of the sample devices according to Examples 1 and 2, and the Comparative Example 1 are evaluated by irradiating light with a wavelength of 395 nm.

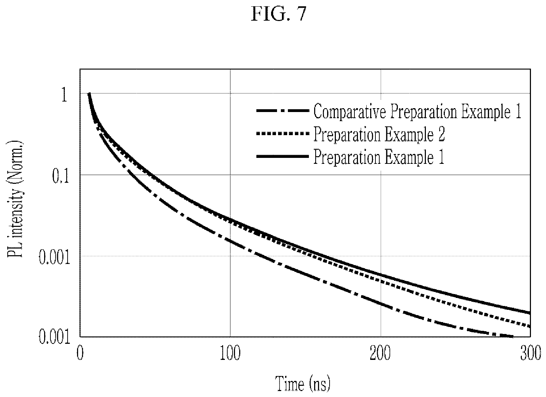

The results are shown in FIG. 7.

FIG. 7 is a graph showing the photoluminescence life-span characteristics of sample devices according to Examples 1 and 2, and Comparative Example 1.

Referring to FIG. 7, the sample devices according to Examples 1 and 2 exhibits sufficient photoluminescence life-span characteristics due to less quenching, compared with the sample device according to Comparative Example 1.

Manufacturing of Quantum Dot Light Emitting Device I

Example 3

Surface-treatment with UV-ozone is performed for 15 minutes on a glass substrate on which an ITO anode is deposited, a Poly(3,4-ethylene dioxythiophene):polystyrene sulfonate (PEDOT:PSS) solution is spin-coated, heat-treatment is performed in an air atmosphere at 150 °C for 10 minutes, and then heat-treatment is performed again in a $N_2$ atmosphere at 150 °C for 30 minutes to form a 30 nm-thick lower hole auxiliary layer. Then, poly[(9,9-dioctylfluorenyl-2,7-di-co-(4,4'-(N-4-butylphenyl)diphenylamine] solution (TFB, Sumitomo) is spin-coated on the lower hole auxiliary layer and heat-treated at 180 °C for 30 minutes to form a 25 nm-thick upper hole auxiliary layer. On the upper hole auxiliary layer, the quantum dot dispersion of Preparation Example 1 is spin-coated and heat-treated at 80 °C for 30 minutes to form a 20 nm-thick lower quantum dot light emitting layer. Subsequently, on the lower quantum dot light emitting layer, the quantum dot dispersion according to Preparation Example 1 is spin-coated and heat-treated at 80 °C for 30 minutes to form a 30 nm-thick upper quantum dot light emitting layer. Then, the alkaline-earth metal oxide nanoparticle dispersion according to Preparation Example 2 is spin-coated on the upper quantum dot light emitting layer, and heat-treated at 80 °C for 30 minutes to form a 20 nm-thick electron auxiliary layer. Then, on the electron auxiliary layer, Al is vacuum-deposited to be 100 nm thick to form a cathode (WF: 4.2 eV), manufacturing a quantum dot light emitting device.

Comparative Example 2

A quantum dot light emitting device is manufactured in the same manner as in Example 3 except that the alkaline-earth metal oxide nanoparticle dispersion according to Comparative Preparation Example 1 is used instead of the alkaline-earth metal oxide nanoparticle dispersion according to Preparation Example 2.

Comparative Example 3

A quantum dot light emitting device is manufactured in the same manner as in Example 3 except that the ZnO nanoparticle dispersion according to Comparative Preparation Example 2 is used instead of the alkaline-earth metal oxide nanoparticle dispersion according to Preparation Example 2.

Evaluation V

The quantum dot light emitting devices according to Example 3 and Comparative Examples 2 and 3 are evaluated with respect to electrical characteristics, luminescence characteristics, and life-span characteristics.

The electrical characteristics and luminescence characteristics of the quantum dot light emitting devices are measured by using a current-voltage-luminance measuring equipment (Keithley 2200, Minolta CS200).

The life-span characteristics of the quantum dot light emitting device are evaluated by a decrease in luminance from initial luminance by injecting a current that meets a condition that the quantum dot light emitting devices exhibit luminance of 650 candela per square meter ($cd/m^2$) or nit, wherein $T_{90}$, $T_{70}$, and $T_{50}$ are evaluated as time taken for showing 90%, 70%, and 50% of the initial luminance.

The results are shown in Table 4.

Table 4

|  | Example 3 | Comparative Example 2 | Comparative Example 3 |
|---|---|---|---|
| $EQE_{max}$ (%) | 13.7 | 9.5 | 6.9 |
| $EQE_{650nt}$ (%) | 12.8 | 5.4 | - |
| $Lum_{max}$ ($cd/m^2$) | 125,917 | 117,311 | 77,978 |
| Maximum current efficiency (cd/A) | 16.4 | 10.1 | - |
| $T_{90}$ (@650 nit) (h) | 55.9 | 37.5 | - |

(continued)

|  | Example 3 | Comparative Example 2 | Comparative Example 3 |
|---|---|---|---|
| $T_{70}$ (@650 nit) (h) | 150.6 | 108.3 | - |
| $T_{50}$ (@650 nit) (h) | 233.7 | 192.4 | 91.1 |
| Init. V (V) | 2.68 | 2.73 | - |
| * $EQE_{max}$: maximum external quantum efficiency<br>* $EQE_{650nt}$: external quantum efficiency at 650nit<br>* $Lum_{max}$: maximum light emitting luminance<br>* Init. V is also referred to as driving voltage. | | | |

Referring to Table 4, the quantum dot light emitting device according to Example 3, compared with the quantum dot light emitting device according to Comparative Example 2, exhibits improved electrical characteristics, luminescence characteristics, and life-span characteristics. In addition, the quantum dot light emitting device of Comparative Example 3, which includes ZnO nanoparticles as an electron auxiliary material, exhibits deteriorated electrical characteristics, luminescence characteristics, and life-span characteristics, compared with the quantum dot light emitting device according to Example 3.

Manufacturing of Quantum Dot Light Emitting Device II

Example 4

After surface-treating a glass substrate deposited with an ITO anode with UV-ozone for 15 minutes, an ink containing PEDOT:PSS is spin-coated thereon to form a 140 nm-thick lower hole auxiliary layer. Subsequently, on the lower hole auxiliary layer, an ink including poly[(9,9-dioctylfluoren-2,7-diyl-co-(4,4'-(N-4-butylphenyl)diphenylamine] (TFB) is spin-coated to form a 35 nm-thick upper hole auxiliary layer. After a VCD process at $10^{-3}$ Torr, a heat treatment is performed at 230 °C for 30 minutes. Subsequently, on the upper hole auxiliary layer, the quantum dot dispersion according to Preparation Example 1 is spin-coated and heat-treated at 140 °C for 30 minutes to form a 30 nm-thick quantum dot light emitting layer. On the quantum dot light emitting layer, an ink prepared by dispersing the alkaline-earth metal oxide nanoparticle according to Preparation Example 2 in a solvent is spin-coated and heat-treated at 140 °C for 30 minutes to form a 50 nm-thick electron auxiliary layer. On the electron auxiliary layer, Al is vacuum-deposited to form a 100 nm-thick cathode (WF: 4.2 eV), manufacturing a quantum dot light emitting device.

Comparative Example 4

A quantum dot light emitting device is manufactured in the same manner as in Example 4 except that the alkaline-earth metal oxide nanoparticle dispersion according to Comparative Preparation Example 1 is used instead of the alkaline-earth metal oxide nanoparticle dispersion according to Preparation Example 2.

Evaluation VI

The quantum dot light emitting devices according to Example 4 and Comparative Example 4 are evaluated with respect to the electrical characteristics, luminescence properties, and lifespan properties.
The results are shown in Table 5.

Table 5

|  | Example 4 | Comparative Example 4 |
|---|---|---|
| EQE@20000 nt (%) | 9.6 | 7.7 |
| $Lum_{max}$ (cd/m$^2$) | 70,500 | 30,852 |
| $T_{90}$ (@650 nit) (h) | 228.6 | 36.6 |
| $T_{70}$ (@650 nit) (h) | 387.6 | 66.8 |
| Init. V (V) | 2.69 | 2.77 |
| * EQE@20000nt: External quantum efficiency at 20000 nit | | |

Referring to Table 5, the quantum dot light emitting device according to Example 4, compared with the quantum dot light emitting device according to Comparative Example 4, exhibits improved electrical characteristics, luminescence characteristics, and life-span characteristics.

While this disclosure has been described in connection with what is presently considered to be practical example embodiments, it is to be understood that the invention is not limited to the disclosed embodiments. On the contrary, it is intended to cover various modifications and equivalent arrangements included within the scope of the appended claims.

**Claims**

1. A method of manufacturing a quantum dot light emitting device, comprising:

    forming an anode,
    forming a quantum dot light emitting layer on the anode,
    forming an electron auxiliary layer on the quantum dot light emitting layer, the electron auxiliary layer comprising alkaline-earth metal containing oxide nanoparticles, and
    forming a cathode on the electron auxiliary layer,
    wherein the forming of the electron auxiliary layer comprises:

        preparing a precursor dispersion including an alkaline-earth metal precursor,
        preparing a basic reagent solution containing a basic reagent,
        adding the basic reagent solution into the precursor dispersion by dropping dropwise at a controlled rate to grow alkaline earth metal containing oxide nanoparticles,
        dispersing the alkaline-earth metal containing oxide nanoparticles in a dispersion medium to prepare an alkaline-earth metal containing oxide nanoparticle dispersion, and
        coating the alkaline-earth metal containing oxide nanoparticle dispersion on the quantum dot light emitting layer.

2. The method of claim 1, wherein the basic reagent comprises an inorganic alkali hydroxide;
    preferably wherein the inorganic alkali hydroxide comprises CsOH, RbOH, KOH, NaOH, LiOH, or any combination thereof.

3. The method of claims 1 or 2, wherein the basic reagent solution is added by dropping dropwise at a rate of 0.1 millimole/minute to 1.5 millimole/minute;
    preferably wherein the basic reagent solution is added by dropping dropwise at a rate of 0.2 millimole/minute to 1.2 millimole/minute.

4. The method of any of claims 1-3, wherein the precursor dispersion comprises a zinc precursor.

5. The method of any of claims 1-4, wherein the alkaline-earth metal containing oxide nanoparticles satisfy Relational Equation 1:

$$\text{Relational Equation 1}$$

$$0.075 \le 1 - (Abs_{valley} / Abs_{peak}) \le 0.095$$

wherein, in Relational Equation 1,

    $Abs_{peak}$ is an absorbance at the peak of the ultraviolet-visible absorption spectrum, and
    $Abs_{valley}$ is an absorbance at the lowest point of the valley adjacent to the peak of the ultraviolet-visible absorption spectrum.

6. The method of claim 5, wherein an average particle diameter of the alkaline-earth metal containing oxide nanoparticles is 1.2 nanometers to 2.2 nanometers; and/or
    wherein an average particle diameter (nm) of aggregates of the alkaline-earth metal containing oxide nanoparticles measured by dynamic light scattering is 6 nanometers to 15 nanometers.

7. The method of claims 5 or 6, wherein an average circularity of the alkaline-earth metal containing oxide nanoparticles is 0.70 to 1.00.

8. A quantum dot light emitting device, comprising:

an anode and a cathode,
a quantum dot light emitting layer between the anode and the cathode, and
an electron auxiliary layer between the cathode and the quantum dot light emitting layer, the electron auxiliary layer comprising alkaline-earth metal containing oxide nanoparticles,
wherein the alkaline-earth metal containing oxide nanoparticles satisfy Relational Equation 1:

## Relational Equation 1

$$0.075 \le 1 - (Abs_{valley} / Abs_{peak}) \le 0.095$$

wherein, in Relational Equation 1,
$Abs_{peak}$ is an absorbance at the peak of the ultraviolet-visible absorption spectrum, and
$Abs_{valley}$ is an absorbance at a lowest point of the valley adjacent to the peak of the ultraviolet-visible absorption spectrum.

9. The quantum dot light emitting device of claim 8, wherein an average particle diameter of the alkaline-earth metal containing oxide nanoparticles is 1.2 nanometers to 2.2 nanometers; and/or
wherein an average particle diameter of aggregates of the alkaline-earth metal containing oxide nanoparticles measured by dynamic light scattering is 6 nanometers to 15 nanometers.

10. The quantum dot light emitting device of claims 8 or 9, wherein an average circularity of the alkaline-earth metal containing oxide nanoparticles is 0.70 to 1.00.

11. The quantum dot light emitting device of any of claims 8-10, wherein the alkaline-earth metal is magnesium.

12. The quantum dot light emitting device of any of claims 8-11, wherein the alkaline-earth metal containing oxide nanoparticles comprises zinc;
preferably wherein an amount of the alkaline-earth metal included in the alkaline-earth metal containing oxide nanoparticles is 0.01 to 30 atomic percentage based on a total number of atoms of the alkaline-earth metal and zinc.

13. The quantum dot light emitting device of any of claims 8-12, wherein the alkaline-earth metal containing oxide nanoparticles comprise an element of Cs, Rb, K, Na, Li, or a combination thereof, or a salt thereof.

14. The quantum dot light emitting device of any of claims 8-13, comprising a hole auxiliary layer between the anode and the quantum dot light emitting layer, the hole auxiliary layer comprising an organic material.

15. An electronic device comprising the quantum dot light emitting device of any of claims 8-14.

FIG. 1

<u>10</u>

FIG. 2

FIG. 3

FIG. 4

FIG. 5

FIG. 6

FIG. 7

Europäisches
Patentamt

European
Patent Office

Office européen
des brevets

## EUROPEAN SEARCH REPORT

**Application Number**

EP 25 15 2745

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | HAN CHANG-YEOL ET AL: "More Than 9% Efficient ZnSeTe Quantum Dot-Based Blue Electroluminescent Devices", ACS ENERGY LETTERS, vol. 5, no. 5, 14 April 2020 (2020-04-14), pages 1568-1576, XP093289211, American Chemical Society ISSN: 2380-8195, DOI: 10.1021/acsenergylett.0c00638 Retrieved from the Internet: URL:https://pubs.acs.org/doi/pdf/10.1021/a csenergylett.0c00638> * page 1576; figures 2a-2f, 3a-3c * ----- | 1-15 | INV. H10K50/115 H10K50/16 |
| X | Han Chang-Yeol ET AL: "Supporting Information Over 9% Efficient ZnSeTe Quantum Dot-Based Blue Electroluminescent Devices", , 14 April 2020 (2020-04-14), pages s1-s13, XP093289220, Retrieved from the Internet: URL:https://pubs.acs.org/doi/10.1021/acsen ergylett.0c00638?goto=supporting-info * page 2 - page 9; figure s8b * ----- | 1-15 | |
| A | US 2022/149311 A1 (SEO HONGKYU [KR] ET AL) 12 May 2022 (2022-05-12) * paragraphs [0008] - [0012], [0097] - [0100], [0112] - [0116], [0144] * ----- -/-- | 12,13 | **TECHNICAL FIELDS SEARCHED (IPC)** H10K |

The present search report has been drawn up for all claims

| Place of search | Date of completion of the search | Examiner |
|---|---|---|
| The Hague | 24 June 2025 | Chin, Patrick |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

**EUROPEAN SEARCH REPORT**

**Application Number**

EP 25 15 2745

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | ZHENXING ZHANG ET AL: "High-Performance, Solution-Processed, and Insulating-Layer-Free Light-Emitting Diodes Based on Colloidal Quantum Dots", ADVANCED MATERIALS, VCH PUBLISHERS, DE, vol. 30, no. 28, 28 May 2018 (2018-05-28), page n/a, XP071872715, ISSN: 0935-9648, DOI: 10.1002/ADMA.201801387 * the whole document * ----- | 1-15 | |

TECHNICAL FIELDS
SEARCHED        (IPC)

The present search report has been drawn up for all claims

| Place of search | Date of completion of the search | Examiner |
|---|---|---|
| The Hague | 24 June 2025 | Chin, Patrick |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

....................................................................................

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 25 15 2745

This annex lists the patent family members relating to the patent documents cited in  the above-mentioned European search report.
The members are as contained in the European Patent Office EDP file on
The European Patent Office is in no way liable for these particulars which are merely given for the purpose of information.

24-06-2025

| Patent document cited in search report | Publication date | Patent family member(s) | Publication date |
|---|---|---|---|
| US 2022149311    A1 | 12-05-2022 | KR   20220062885 A | 17-05-2022 |
|  |  | US    2022149311 A1 | 12-05-2022 |

EPO FORM P0459

For more details about this annex : see Official Journal of the European Patent Office, No. 12/82